# EUROPEAN PATENT APPLICATION

(11) **EP 4 844 735 A1**
(43) Date of publication of application: **25.11.2026**
(21) Application number: 24919271.7
(22) Date of filing: 24.01.2024
(51) Int. Cl.: G09F 9/33, H10H 20/85, H10H 29/01

(54) **DISPLAY PANEL, DISPLAY APPARATUS, AND TILED DISPLAY APPARATUS**

(71) Applicant: Boe Technology Group Co., Ltd., Beijing 100015 (CN); BOE MLED Technology Co., Ltd., Beijing 100176 (CN)
(72) Inventor: ZHAO, Jingping, Beijing 100176 (CN); LIU, Chao, Beijing 100176 (CN); HAN, Shiwei, Beijing 100176 (CN); WANG, Lili, Beijing 100176 (CN); FENG, Shanshan, Beijing 100176 (CN); JIA, Mingming, Beijing 100176 (CN); WANG, Jing, Beijing 100176 (CN); FENG, Sha, Beijing 100176 (CN); LIU, Mengqing, Beijing 100176 (CN); WANG, Huaimin, Beijing 100176 (CN); ZHAI, Ming, Beijing 100176 (CN); QI, Qi, Beijing 100176 (CN); WANG, Huan, Beijing 100176 (CN)
(74) Representative: Hoffmann Eitle
(86) International application number: PCT/CN2024/073846
(87) International publication number: WO 2025/156156

(57) **Abstract**

A display panel, a display apparatus, and a tiled display apparatus. The display panel comprises a substrate and a plurality of recessed regions. The substrate comprises a first surface and a second surface which are oppositely arranged, and at least one side surface connecting the first surface and the second surface. At least one of the at least one side surface is a selected side surface. The plurality of recessed regions are arranged at intervals in a first direction. Each of the recessed regions comprises a first recessed sub-region located on the first surface, a second recessed sub-region located on the second surface, and a side-surface recessed sub-region located on the selected side surface. Each of the recessed regions further comprises a first transition recessed sub-region connecting the first recessed sub-region and the side-surface recessed sub-region, and/or a second transition recessed sub-region connecting the second recessed sub-region and the side-surface recessed sub-region. The first transition recessed sub-region comprises a first mesh recess, and/or the second transition recessed sub-region comprises a second mesh recess. The display panel is used for displaying images.

## Description

### TECHNICAL FIELD

The present disclosure relates to the field of display technologies, and in particular, to a display panel, a display apparatus and a tiled display apparatus.

### BACKGROUND

Micro light-emitting diodes (Micro LEDs) or mini light-emitting diodes (Mini LEDs) are used as pixels of display panels, which has attracted widespread attention and research. At present, large-size display apparatuses cannot be fabricated at one time due to the problem of the mass transfer yield of Micro LED display panels and Mini LED display panels. A large-size tiled display apparatus is usually fabricated by tiling small-size display apparatuses.

### SUMMARY

In an aspect, a display panel is provided. The display panel includes a substrate and a plurality of depression regions.

The substrate includes a first surface and a second surface that are oppositely disposed, and at least one side surface connecting the first surface and the second surface. At least one of the side surface is a selected side surface.

The plurality of depression regions are arranged at intervals in a first direction, each depression region extends from the first surface to the second surface through the selected side surface. Each depression region includes a first depression sub-region located on the first surface, a second depression sub-region located on the second surface, and a side depression sub-region located on the selected side surface.

Each first depression sub-region and each second depression sub-region extend in a second direction. Each side depression sub-region extends in a third direction. The second direction is perpendicular to the selected side surface, the first direction is perpendicular to the second direction, and the third direction is perpendicular to the first surface or the second surface.

Each depression region further includes a first transition depression sub-region connecting the first depression sub-region and the side depression sub-region, and/or, a second transition depression sub-region connecting the second depression sub-region and the side depression sub-region.

The first transition depression sub-region includes a first grid-like depression portion, and/or, the second transition depression sub-region includes a second grid-like depression portion.

In some embodiments, the first depression sub-region includes a plurality of first grooves arranged in parallel, the second depression sub-region includes a plurality of second grooves arranged in parallel, and the side depression sub-region includes a plurality of side grooves arranged in parallel.

In some embodiments, a first groove extends to the first transition depression sub-region, and/or, a second groove extends to the second transition depression sub-region, and/or, a side groove extends to the first transition depression sub-region and the second transition depression sub-region.

The first transition depression sub-region includes a plurality of first transition grooves arranged in parallel, an extending direction of a first transition groove has a first included angle with an extending direction of at least one of the first groove and the side groove, and the first transition grooves cross at least one of the first grooves and the side grooves to form the first grid-like depression portion.

And/or, the second transition depression sub-region includes a plurality of second transition grooves arranged in parallel, an extending direction of a second transition groove has a second included angle with an extending direction of at least one of the second groove and the side groove, and the second transition grooves cross at least one of the second grooves and the side grooves to form the second grid-like depression portion.

In some embodiments, a dimension of the first transition depression sub-region in the first direction is greater than or equal to a dimension of the side depression sub-region in the first direction; and/or, a dimension of the second transition depression sub-region in the first direction is greater than or equal to the dimension of the side depression sub-region in the first direction.

In some embodiments, the substrate further includes a first chamfered surface and a second chamfered surface.

The first chamfered surface connects the first surface and the selected side surface, and the second chamfered surface connects the second surface and the selected side surface.

The first transition depression sub-region is disposed on at least the first chamfered surface, and the second transition depression sub-region is disposed on at least the second chamfered surface.

In some embodiments, the first transition depression sub-region extends to the selected side surface, and/or, the first transition depression sub-region extends to the first surface.

In some embodiments, the second transition depression sub-region extends to the selected side surface, and/or, the second transition depression sub-region extends to the second surface.

In some embodiments, a dimension of an orthogonal projection of the first chamfered surface on a plane where the first surface is located in the second direction is greater than or equal to 10 µm and less than or equal to 50 µm.

A dimension of an orthogonal projection of the second chamfered surface on a plane where the second surface is located in the second direction is greater than or equal to 10 µm and less than or equal to 50 µm.

In some embodiments, a dimension of the first depression sub-region in the first direction is greater than or equal to a dimension of the side depression sub-region in the first direction.

In some embodiments, the dimension of the first depression sub-region in the first direction is equal to a dimension of the first transition depression sub-region in the first direction.

In some embodiments, a dimension of the depression region in the first direction is greater than or equal to 25 µm.

In some embodiments, the display panel further includes a plurality of first electrodes located on the first surface of the substrate, and the plurality of first electrodes are arranged at intervals in the first direction.

A depression region is disposed between two adjacent first electrodes. A dimension of the depression region in the first direction is less than or equal to 70% of a distance between the two first electrodes adjacent thereto.

In some embodiments, the plurality of first transition grooves are parallel to each other; and/or, the plurality of second transition grooves are parallel to each other.

In some embodiments, a depth of each first transition groove is within a range of 1 µm to 3 µm, inclusive; and/or, a width of each first transition groove is within a range of 1 µm to 10 µm, inclusive.

A depth of each second transition groove is within a range of 1 µm to 3 µm, inclusive; and/or, a width of each second transition groove is within a range of 1 µm to 10 µm, inclusive.

In some embodiments, at least two of the plurality of first transition grooves have different depths, and/or, at least two of the plurality of first transition grooves have different widths.

At least two of the plurality of second transition grooves have different depths, and/or, at least two of the plurality of second transition grooves have different widths.

In some embodiments, the side depression sub-region is provided with a plurality of side grooves extending in the third direction, and the plurality of side grooves are arranged at intervals in the first direction.

The plurality of side grooves overlap with a plurality of first transition grooves on the selected side surface of the substrate; and/or, the plurality of side grooves overlap with a plurality of second transition grooves on the selected side surface of the substrate.

In some embodiments, the display panel further includes an insulating layer located on the first surface of the substrate, and a border of the insulating layer extends along an edge of the substrate.

The first depression sub-region is provided with a plurality of first grooves, and at least one of the plurality of first grooves or at least partial region of the plurality of first grooves overlaps with the insulating layer.

In some embodiments, the display panel further includes a connection lead disposed between two adjacent depression regions. The connection lead extends from the first surface to the second surface through the selected side surface.

The connection lead includes a first lead segment located on the first surface, a second lead segment located on the second surface, a side lead segment located on the selected side surface, and a first transition lead segment connecting the first lead segment and the side lead segment and/or a second transition lead segment connecting the second lead segment and the side lead segment.

A dimension of the first transition lead segment in the first direction is less than or equal to a dimension of the side lead segment in the first direction; and/or, a dimension of the second transition lead segment in the first direction is less than or equal to the dimension of the side lead segment in the first direction.

In some embodiments, the substrate further includes a first chamfered surface and a second chamfered surface. The first chamfered surface connects the first surface and the selected side surface, and the second chamfered surface connects the second surface and the selected side surface.

The first transition lead segment is disposed on at least the first chamfered surface, and the second transition lead segment is disposed on at least the second chamfered surface.

In some embodiments, a dimension of the connection lead in the first direction is greater than or equal to 60 µm.

In some embodiments, the display panel further includes a protective layer. The protective layer is filled in the plurality of depression regions and covers surfaces of a plurality of connection leads away from the substrate.

In another aspect, a display apparatus is provided. The display apparatus includes the display panel as described in any of the above embodiments and a circuit board.

The display panel includes a plurality of connection leads, and a connection lead is disposed between each two adjacent etching grooves.

The circuit board is electrically connected to the plurality of connection leads.

In yet another aspect, a tiled display apparatus is provided. The tiled display apparatus includes a plurality of display panels each as described in any of the above embodiments and at least one circuit board.

The plurality of display panels are tiled together. Each display panel includes a plurality of connection leads, and a connection lead is disposed between each two adjacent etching grooves. Each of the at least one circuit board is electrically connected to a plurality of connection leads of at least one of the display panels.

### BRIEF DESCRIPTION OF THE DRAWINGS

In order to describe technical solutions in the present disclosure more clearly, the accompanying drawings to be used in some embodiments of the present disclosure will be introduced briefly. However, the accompanying drawings to be described below are merely drawings of some embodiments of the present disclosure, and a person of ordinary skill in the art may obtain other drawings according to these accompanying drawings. In addition, the accompanying drawings in the following description may be regarded as schematic diagrams, but are not limitations on actual sizes of products, actual processes of methods and actual timings of signals involved in the embodiments of the present disclosure.
FIG. 1 is a diagram showing a structure of a tiled display apparatus, in accordance with some embodiments of the present disclosure;
FIG. 2 is a diagram showing a structure of a display apparatus, in accordance with some embodiments of the present disclosure;
FIG. 3 is a sectional view of the display apparatus in FIG. 2 taken along the section line B-B;
FIG. 4A is a diagram showing a structure of a partial region of a display apparatus, in accordance with some embodiments of the present disclosure;
FIG. 4B is a diagram showing another structure of a partial region of a display apparatus, in accordance with some embodiments of the present disclosure;
FIG. 5A is a diagram showing a structure of a display panel, in accordance with some embodiments of the present disclosure;
FIG. 5B is a diagram showing another structure of a display panel, in accordance with some embodiments of the present disclosure;
FIG. 5C is a diagram showing yet another structure of a display panel, in accordance with some embodiments of the present disclosure;
FIG. 6A is a diagram showing yet another structure of a display panel, in accordance with some embodiments of the present disclosure;
FIG. 6B is a diagram showing yet another structure of a display panel, in accordance with some embodiments of the present disclosure;
FIG. 7 is a diagram showing yet another structure of a display panel, in accordance with some embodiments of the present disclosure;
FIG. 8A is a flow chart of a process of manufacturing a plurality of connection leads, in accordance with some embodiments of the present disclosure;
FIG. 8B is a diagram showing a structure of a display panel corresponding to the step R1 in the process of manufacturing the plurality of connection leads in FIG. 8A;
FIG. 8C is a diagram showing a structure of a display panel corresponding to the step R2 in the process of manufacturing the plurality of connection leads in FIG. 8A;
FIG. 8D is a diagram showing yet another structure of a display panel, in accordance with some embodiments of the present disclosure;
FIG. 8E is a diagram showing yet another structure of a display panel, in accordance with some embodiments of the present disclosure;
FIG. 8F is a diagram showing yet another structure of a display panel, in accordance with some embodiments of the present disclosure;
FIG. 8G is a diagram showing yet another structure of a display panel, in accordance with some embodiments of the present disclosure;
FIG. 9A is a diagram showing yet another structure of a display panel, in accordance with some embodiments of the present disclosure;
FIG. 9B is a diagram showing yet another structure of a display panel, in accordance with some embodiments of the present disclosure;
FIG. 9C is a diagram showing yet another structure of a display panel, in accordance with some embodiments of the present disclosure;
FIG. 10A is a diagram showing yet another structure of a display panel, in accordance with some embodiments of the present disclosure;
FIG. 10B is a diagram showing yet another structure of a display panel, in accordance with some embodiments of the present disclosure;
FIG. 11 is a diagram showing yet another structure of a display panel, in accordance with some embodiments of the present disclosure;
FIG. 12 is a diagram showing yet another structure of a display panel, in accordance with some embodiments of the present disclosure;
FIG. 13A is a diagram showing yet another structure of a display panel, in accordance with some embodiments of the present disclosure;
FIG. 13B is a diagram showing yet another structure of a display panel, in accordance with some embodiments of the present disclosure;
FIG. 14 is a diagram showing yet another structure of a display panel, in accordance with some embodiments of the present disclosure;
FIG. 15A is a diagram showing yet another structure of a display panel, in accordance with some embodiments of the present disclosure;
FIG. 15B is a diagram showing yet another structure of a display panel, in accordance with some embodiments of the present disclosure;
FIG. 16 is a diagram showing yet another structure of a display panel, in accordance with some embodiments of the present disclosure;
FIG. 17 is a diagram showing yet another structure of a display panel, in accordance with some embodiments of the present disclosure;
FIG. 18 is a flow chart of a method for manufacturing a display panel, in accordance with some embodiments of the present disclosure;
FIG. 19 is a flow chart of the step S3 in the method for manufacturing the display panel in FIG. 18;
FIG. 20 is a diagram showing a structure of a display panel corresponding to the step S3 in the method for manufacturing the display panel in FIG. 19;
FIG. 21A is a sectional view of the first transition grooves in FIG. 8E taken along the section line P-P';
FIG. 21B is a sectional view of the second transition grooves in FIG. 8E taken along the section line Q-Q';
FIG. 22 is a diagram showing a structure of a depression region of a display panel corresponding to the step S31 in the method for manufacturing the display panel in FIG. 19;
FIG. 23A is a diagram showing a structure of a display panel corresponding to the step S34 in the method for manufacturing the display panel in FIG. 19;
FIG. 23B is a diagram showing another structure of a display panel corresponding to the step S34 in the method for manufacturing the display panel in FIG. 19;
FIG. 24 is a diagram showing a structure of an insulating layer groove, in accordance with some embodiments of the present disclosure;
FIG. 25 is a sectional view of the second transition depression sub-region K15 in FIG. 8E taken along the section line R-R'; and
FIG. 26 is a diagram showing another structure of a plurality of first transition grooves, in accordance with some embodiments of the present disclosure.

### DETAILED DESCRIPTION

The technical solutions in some embodiments of the present disclosure will be described clearly and completely with reference to the accompanying drawings. However, the described embodiments are merely some but not all embodiments of the present disclosure. All other embodiments obtained by a person of ordinary skill in the art based on embodiments of the present disclosure shall be included in the protection scope of the present disclosure.

Unless the context requires otherwise, throughout the description and the claims, the term "comprise" and other forms thereof such as the third-person singular form "comprises" and the present participle form "comprising" are construed as an open and inclusive meaning, i.e., "including, but not limited to". In the description of the specification, the terms such as "one embodiment", "some embodiments", "exemplary embodiments", "example", "specific example", or "some examples" are intended to indicate that specific features, structures, materials, or characteristics related to the embodiment(s) or example(s) are included in at least one embodiment or example of the present disclosure. Schematic representations of the above terms do not necessarily refer to the same embodiment(s) or example(s). In addition, the specific features, structures, materials, or characteristics may be included in any one or more embodiments or examples in any suitable manner.

The terms "first" and "second" are used for descriptive purposes only, and are not to be construed as indicating or implying a relative importance or implicitly indicating the number of indicated technical features. Thus, a feature defined with "first" or "second" may explicitly or implicitly include one or more of the features. In the description of the embodiments of the present disclosure, the term "a/the plurality of" means two or more unless otherwise specified.

In the description of some embodiments, the expression "connected", and derivative thereof may be used. The term "connected" should be understood in a broad sense. For example, the term "connected" may represent a fixed connection, a detachable connection, or a one-piece connection, or may represent a direct connection, or may represent an indirect connection through an intermediate medium. The term "coupled", for example, indicates that two or more components are in direct physical or electrical contact with each other. The term "coupled" or "communicatively coupled" may also mean that two or more components are not in direct contact with each other but still cooperate or interact with each other. The embodiments disclosed here are not necessarily limited to the content herein.

The phrase "at least one of A, B, and C" has the same meaning as the phrase "at least one of A, B, or C", both including the following combinations of A, B, and C: only A, only B, only C, a combination of A and B, a combination of A and C, a combination of B and C, and a combination of A, B, and C.

The phrase "A and/or B" includes following three combinations: only A, only B, and a combination of A and B.

The phrase "applicable to" or "configured to" used herein means an open and inclusive expression, which does not exclude devices that are applicable to or configured to perform additional tasks or steps.

In addition, the phase "based on" as used herein is meant to be open and inclusive, since a process, a step, a calculation or other action that is "based on" one or more of stated conditions or values may, in practice, be based on additional conditions or values beyond those stated.

The term "about", "substantially", and "approximately" as used herein includes a stated value and an average value within an acceptable range of deviation of a particular value determined by a person of ordinary skill in the art, considering measurement in question and errors associated with measurement of a particular quantity (i.e., limitations of a measurement system).

The term such as "parallel", "perpendicular", or "equal" as used herein includes a stated condition and a condition similar to the stated condition. A range of the similar condition is within an acceptable range of deviation, and the acceptable range of deviation is determined by a person of ordinary skill in the art, considering measurement in question and errors associated with measurement of a particular quantity (i.e., the limitations of a measurement system). For example, the term "parallel" includes absolute parallelism and approximate parallelism, and an acceptable range of deviation of the approximate parallelism may be a deviation within 5°; the term "perpendicular" includes absolute perpendicularity and approximate perpendicularity, and an acceptable range of deviation of the approximate perpendicularity may also be a deviation within 5°; and the term "equal" includes absolute equality and approximate equality, and an acceptable range of deviation of the approximate equality may be a difference between two equals being less than or equal to 5% of either of the two equals.

It will be understood that, when a layer or element is referred to as being on another layer or substrate, it may be that the layer or element is directly on the another layer or substrate, or it may be that intervening layer(s) exist between the layer or element and the another layer or substrate.

Exemplary embodiments are described herein with reference to sectional views and/or plan views as idealized exemplary drawings. In the accompanying drawings, thicknesses of layers and areas of regions are enlarged for clarity. Thus, variations in shape with respect to the accompanying drawings due to, for example, manufacturing technologies and/or tolerances may be envisaged. And the exemplary embodiments should not be construed as being limited to the shapes of the regions shown herein, but including shape deviations due to, for example, manufacturing. For example, an etched region shown to have a rectangular shape generally has a curved feature. Therefore, the regions shown in the accompanying drawings are schematic in nature, and their shapes are not intended to show actual shapes of the regions in devices, and are not intended to limit the scope of the exemplary embodiments.

It will be noted that, for example, 1cc/1c appearing in the drawings of the present disclosure indicates that a component 1c includes a component 1cc, and other similar reference signs appearing in the drawings also follow the above description.

For convenience of the following description, an XYZ coordinate system is established. The third direction Z is a thickness direction of a tiled display apparatus or a display apparatus, the XY plane is perpendicular to the Z direction, and the X direction intersects with the Y direction. For example, the X direction and the Y direction are perpendicular to each other.

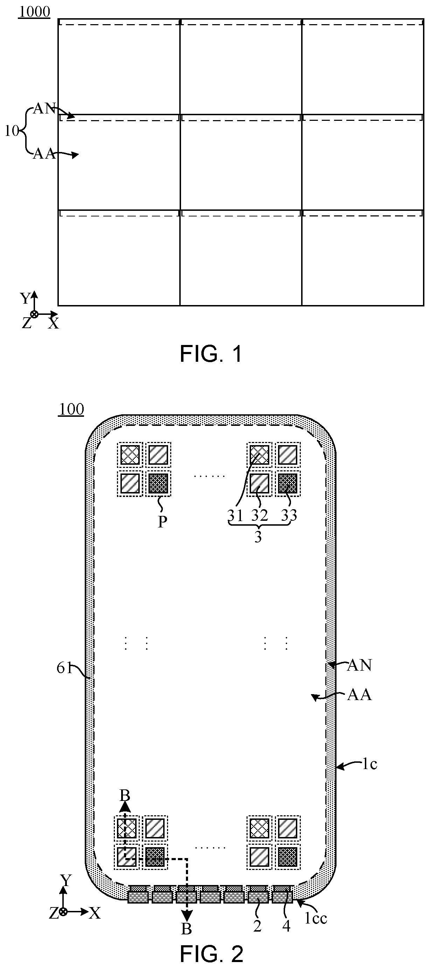

As shown in FIG. 1, a tiled display apparatus 1000 is provided in some embodiments of the present disclosure. The tiled display apparatus 1000 includes a plurality of display panels 10 tiled together and at least one circuit board (not shown in the drawing). Each circuit board is electrically connected to connection lead(s) of at least one display panel 10 and used to control the display panel 10 to emit light, so as achieve the display function of the display panel 10.

Product reliability may be improved and transportation costs and maintenance costs may be reduced by tiling the plurality of display panels 10 to form a large-sized tiled display apparatus 1000.

For example, the number of circuit boards in the tiled display apparatus 1000 may be one, and the plurality of display panels 10 are all connected to a same circuit board.

The number of circuit boards may also be multiple. For example, each display panel 10 in the plurality of display panels 10 is connected to one circuit board. That is to say, the display panels 10 and the circuit boards are connected in one-to-one correspondence. For another example, the plurality of display panels 10 are divided into a plurality of groups, and each group of display panels 10 is connected to one circuit board. The number of display panels 10 in each group of display panels 10 may be same or different.

For example, the circuit board includes but is not limited to a printed circuit board (PCB) and a flexible printed circuit board (FPC).

In some embodiments, the tiled display apparatus 1000 may also be directly formed by tiling a plurality of display apparatuses together, each display apparatus includes a display panel 10 and a circuit board connected to the display panel 10.

A display apparatus is further provided in some embodiments of the disclosure. The display apparatus may be an independent display apparatus or may be used for tiling to form the tiled display apparatus 1000.

The display apparatus will be described in detail below.

The display apparatus may be any product or component having display functions such as a television, a monitor, a notebook computer, a tablet computer, a mobile phone or a navigator. FIG. 2 illustrates an example in which the display apparatus 100 is a mobile phone.

For example, the display apparatus 100 may be a micro light-emitting diode (Micro LED) display apparatus and a mini light-emitting diode (Mini LED) display apparatus.

The display apparatus 100 may also be an electroluminescent display apparatus or a photoluminescence display apparatus. In a case where the display apparatus 100 is the electroluminescent display apparatus, the electroluminescent display apparatus may be an organic light-emitting diode (OLED) display apparatus or a quantum dot light-emitting diodes (QLED) display apparatus. In a case where the display apparatus 100 is the photoluminescent display apparatus, the photoluminescent display apparatus may be a quantum dot photoluminescent display apparatus.

The display apparatus 100 may also be a liquid crystal display (LCD).

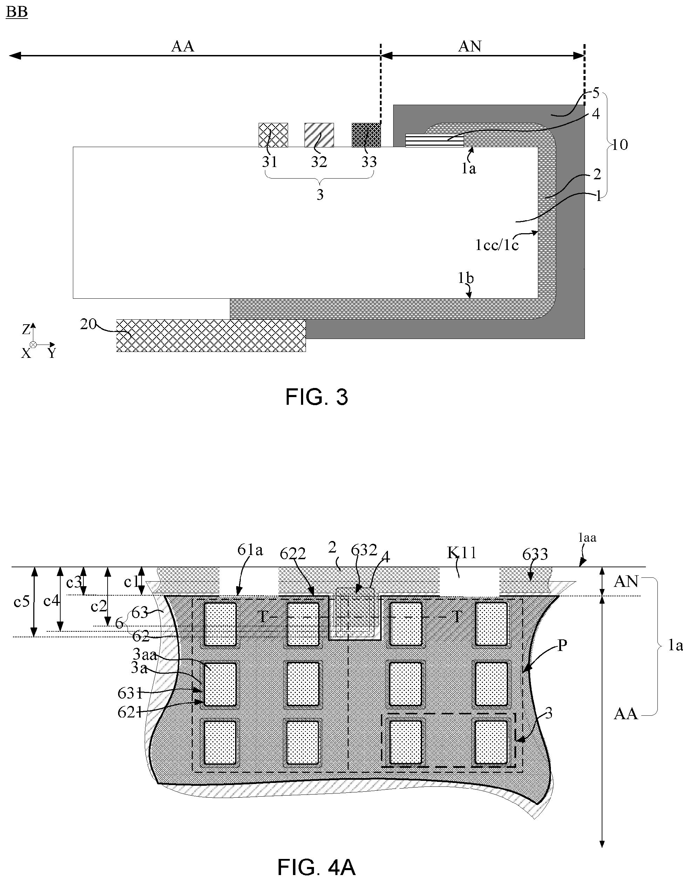

As shown in FIGS. 2 and 3, FIG. 2 is a diagram showing a structure of the display apparatus 100, in accordance with some embodiments of the present disclosure. FIG. 3 is a sectional view of the display apparatus 100 in FIG. 2 taken along the section line B-B. The display apparatus 100 includes a display panel 10 and a circuit board 20. The display panel 10 is electrically connected to the circuit board 20 by connection lead(s) 2.

The display panel 10 will be described in detail below.

The display panel 10 may be a Micro LED display panel, a Mini LED display panel or an OLED display panel, or may also be a liquid crystal display panel.

For example, in a case where the display panel 10 is the Micro LED display panel or the Mini LED display panel, the Micro LED display panel or the Mini LED display panel includes an array substrate and micro light-emitting diodes or mini light-emitting diodes located on the array substrate.

For another example, in a case where the display panel 10 is the OLED display panel, the OLED display panel includes an array substrate and a pixel definition layer located on the array substrate. An anode, a hole injection layer, a hole transport layer, a light-emitting layer, an electron transport layer, an electron injection layer and a cathode are sequentially disposed within a pixel definition region of the pixel definition layer.

For yet another example, in a case where the display panel 10 is the liquid crystal display panel, the liquid crystal display panel includes an array substrate and a color filter substrate that are disposed opposite to each other, and a liquid crystal layer located between the array substrate and the color filter substrate.

Some embodiments of the present disclosure are exemplarily described below by considering an example in which the display panel 10 is the Micro LED display panel or the Mini LED display panel. However, the embodiments of the present disclosure include but are not limited to this, and any other display panel may also be considered as long as a same technical concept is applied.

For example, the display panel 10 may be a rectangular structure, a circular structure, or other shapes with corners, which is not specifically limited in the present disclosure.

It will be noted that, the phrase "rectangular structure" means that a border of the display panel 10 is in a shape of a rectangle as a whole, but is not limited to a standard rectangle. That is to say, the term "rectangle" herein includes not only the standard rectangle but also a shape similar to the rectangle in consideration of process conditions. For example, the long sides and short sides of the rectangle are curved at each intersecting position (i.e., corners). That is to say, the corners are smooth, so that the border of the display panel 10 is in a shape of a rectangle with rounded corners in a plan view.

Some embodiments of the present disclosure are exemplarily described below by considering an example in which the display panel 10 is a rectangular structure. However, the embodiments of the present disclosure include but are not limited to this, and the shape of the display panel 10 may also be considered as any other shape.

With continued reference to FIGS. 1, 2 and 3, the display panel 10 has a display region AA for displaying images and a peripheral region AN located on at least one side of the display region AA.

For example, as shown in FIG. 1, the peripheral region AN is located on a side of the display region AA.

For another example, the peripheral region AN is located on two opposite sides of the display region AA.

For yet another example, as shown in FIG. 2, the peripheral region AN surrounds the display region AA.

It will be noted that the specific arrangement of the peripheral region AN is related to the specific design of the display panel 10 and may be designed according to actual requirements. This is only used as an example, but not a limitation to the present disclosure.

In some embodiments, as shown in FIGS. 2 and 3, a plurality of pixel units P are disposed within the display region AA of the display panel 10, and each pixel unit P includes sub-pixels 3 of at least three colors, and the sub-pixel 3 is a minimum pixel unit within the display region AA.

The "each pixel unit P includes sub-pixels 3 of at least three colors" means that each pixel unit P may include three, four or more sub-pixels 3, and the plurality of sub-pixels 3 included by each pixel unit P may be a row, a column or a group of sub-pixels 3. A group of sub-pixels 3 may be a plurality of sub-pixels 3 adjacent to each other, and the plurality of sub-pixels 3 adjacent to each other may be arranged in a row, a column, a shape of a capital letter L, a rectangular shape or a rhombic shape, etc. Meanwhile, light-emitting areas of the plurality of sub-pixels 3 included by each pixel unit P may be same or different. The above description is only an example and does not limit the present disclosure, detail may be designed adaptively according to actual requirements.

For example, as shown in FIG. 2, the plurality of pixel units P are arranged in a plurality of rows and a plurality of columns.

In some examples, the plurality of sub-pixels 3 emit light of a same color, and the display panel 10 may further include a color film layer disposed on light-exit sides of the plurality of sub-pixels 3.

For example, the plurality of sub-pixels 3 all emit light such as white light, red light, green light or blue light. In this case, light emitted by the sub-pixel 3 remains a same color light and exits after passing through the color film layer, or light emitted by the sub-pixel 3 is converted into light of other color and exits after passing through the color film layer. As a result, in a case where the plurality of sub-pixels 3 emit light of a same color, the display panel 10 may achieve output of light of multiple colors.

In some other examples, the plurality of sub-pixels 3 emit light of different colors. For example, the plurality of sub-pixels 3 include a red light sub-pixel 31 emitting red light, a green light sub-pixel 32 emitting green light, and a blue light sub-pixel 33 emitting blue light, thereby achieving multi-color light output of the display panel 10.

In some embodiments, as shown in FIGS. 2 and 3, the display panel 10 may further include a substrate 1. The plurality of pixel units P are disposed on the substrate 1.

The substrate 1 includes a first surface 1a and a second surface 1b that are oppositely disposed, and at least one side surface 1c connecting the first surface 1a and the second surface 1b. At least one of the side surface is a selected side surface 1cc.

For example, as shown in FIG. 3, the side surface 1c is perpendicular or substantially perpendicular to the first surface 1a and the second surface 1b.

In the XYZ coordinate system described above, the third direction Z is perpendicular to the first surface 1a or the second surface 1b of the substrate 1 and perpendicular to the XY plane, the second direction Y is perpendicular to the selected side surface 1cc of the substrate 1, and the first direction X is perpendicular to the second direction Y.

For example, the substrate 1 may be made of a rigid material. For example, the material of the substrate 1 includes but is not limited to glass, quartz, or plastic. The substrate 1 may also be made of a flexible material. For example, the material of the substrate 1 includes but is not limited to FPC or polyimide film (PI film).

It will be noted that the selected material of the substrate 1 is related to the specific design of the display panel 10 and may be selected according to actual requirements. This is only used as an example, but not a limitation to the present disclosure.

In some embodiments, with continued reference to FIGS. 2 and 3, the display panel 10 further includes a plurality of first electrodes 4. The plurality of first electrodes 4 are disposed on the first surface 1a of the substrate 1 and are arranged at intervals in the first direction X.

For example, as shown in FIG. 4A, FIG. 4A is a diagram showing a structure of a partial region (e.g., a region proximate to an edge of the substrate 1) of the display apparatus 1000, in accordance with some embodiments of the present disclosure. A border of the first surface 1a of the substrate 1 proximate to the selected side surface 1cc is a first border 1aa. At least one first electrode 4 is located between two adjacent sub-pixels 3 in a row of sub-pixels 3 closest to the first border 1aa. That is to say, the first electrode 4 and the sub-pixel 3 simultaneously intersect with at least one straight line (e.g., the straight line TT) parallel to a border of the substrate 1 proximate to the selected side surface 1cc, which is conducive to increasing an area ratio of the display region AA on the first surface 1a of the substrate 1. That is to say, the first electrode 4 may not occupy an area of the peripheral region AN, which may reduce an area ratio of the peripheral region AN of the display panel 10 on the first surface 1a of the substrate 1, and narrow the frame to a large extent, and improve the display effect of the display panel 10.

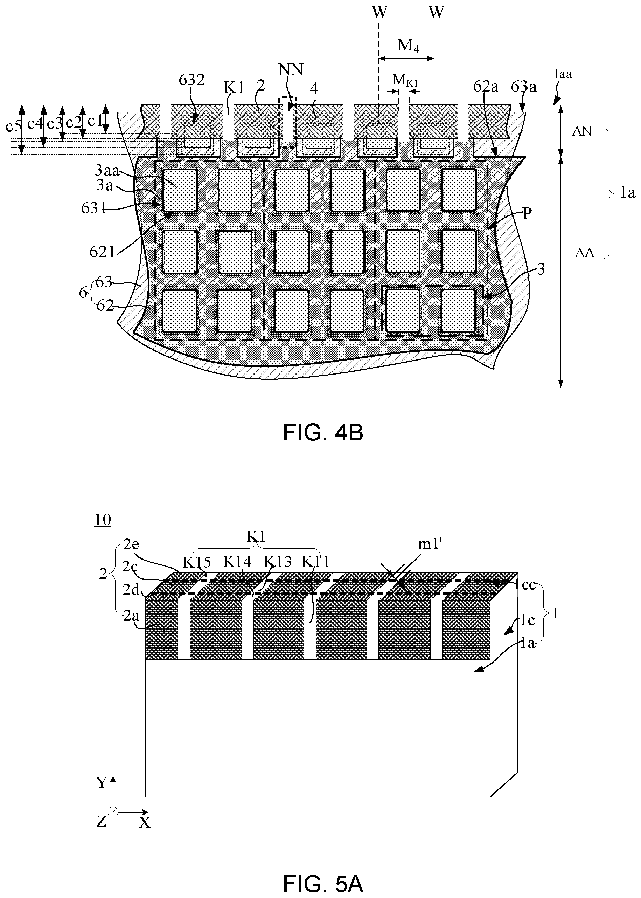

Alternatively, as shown in FIG. 4B, FIG. 4B is a diagram showing another structure of a partial region (e.g., the region proximate to the edge of the substrate 1) of the display apparatus 1000, in accordance with some embodiments of the present disclosure. The plurality of first electrodes 4 are located in the peripheral region AN of the display panel 10. The pixel units P are located within the display region AA of the display panel 10. The first electrodes 4 are located within the peripheral region AN and are closer to the first border 1aa than the pixel units P. There is no straight line parallel to the first border 1aa that intersects with the first electrode 4 and the sub-pixel 3 at the same time. In this case, although the area ratio of the peripheral region AN of the display panel 10 on the first surface 1a of the substrate 1 is increased, the first electrodes 4 may be disposed in a large space. Correspondingly, in a case where a shape and size of the first electrodes 4 remain unchanged, a lot of first electrodes 4 may be disposed, thereby reducing the design difficulty.

In some embodiments, with continued reference to FIGS. 4A and 4B, and in combination with FIG. 2, the display panel 10 further includes an insulating layer 6 located on the first surface 1a of the substrate 1, and the insulating layer 6 includes at least two insulating sub-layers. The insulating sub-layer farthest from the substrate 1 is a first insulating sub-layer 62, and the plurality of insulating sub-layers further include a second insulating sub-layer 63 located between the first insulating sub-layer 62 and the substrate 1. The second insulating sub-layer 63 may be a single-layer structure or a laminate structure.

As shown in FIGS. 4A and 4B, a border of the first surface 1a of the substrate 1 proximate to the selected side surface 1cc is a first border 1aa. An orthogonal projection of the first insulating sub-layer 62 on the substrate 1 has a contour 62a in a region proximate to the first border 1aa, and an orthogonal projection of the second insulating sub-layer 63 on the substrate 1 has a second contour 63a in a region proximate to the selected side surface 1cc. Three sub-pixels 3 are disposed in one pixel unit P, and each sub-pixel 3 includes two conductive pads 3a for connecting a light-emitting device. Therefore, a plurality of first openings 621 are disposed on the first insulating sub-layer 62, and a plurality of second openings 631 are disposed on the second insulating sub-layer 63, so that at least a portion of the conductive pad 3a is exposed as a soldering pad 3aa for connecting with the light-emitting device. An orthogonal projection of the second opening 631 on the substrate 1 is located within an orthogonal projection of the corresponding conductive pad 3a on the substrate 1. An orthogonal projection of the first opening 621 on the substrate 1 is located within an orthogonal projection of the corresponding second opening 631 on the substrate 1. That is to say, a positional relationship among the conductive pad 3a, the second insulating sub-layer 63 and the first insulating sub-layer 62 is that the conductive pad 3a, the second insulating sub-layer 63 and the first insulating sub-layer 62 are sequentially stacked on the substrate 1.

For example, as shown in FIGS. 4A and 4B, the first contour 62a of the orthogonal projection of the first insulating sub-layer 62 on the substrate 1 proximate to the first border 1aa, has a concave-convex shape. The first contour 62a with a concave-convex shape is disposed around a border of the first electrode 4 away from the first border 1aa, and there is no overlapping region between the first insulating sub-layer 62 and the first electrode 4. In the first contour 62a with a concave-convex shape, a convex portion corresponds to a first depression sub-region K11 in a depression region K1, and a concave portion corresponds to the first electrode 4.

For example, as shown in FIGS. 4A and 4B, the second insulating sub-layer 63 is also provided with a plurality of third openings 632, and the plurality of third openings 632 are used for exposing partial surfaces of some first electrodes 4 away from the substrate 1, so that the first electrode 4 may be connected with the connection lead 2 formed subsequently, and an edge region of the first electrode 4 may also be covered to reduce the probability of water and oxygen intrusion. That is to say, a positional relationship among the first electrode 4, the second insulating sub-layer 63 and the first insulating sub-layer 62 is that the first electrode 4, the second insulating sub-layer 63 and the first insulating sub-layer 62 are sequentially stacked on the substrate 1.

For example, as shown in FIGS. 4A and 4B, the orthogonal projection of the second insulating sub-layer 63 on the substrate 1 has a second contour 63a in a region proximate to the selected side surface 1cc. The second contour 63a may be parallel to the first border 1aa, and the second contour 63a is located between the first border 1aa and the first contour 62a.

In some embodiments, with continued reference to FIG. 3, the display panel 10 further includes a plurality of connection leads 2. Each of the plurality of connection leads 2 extends from the first surface 1a of substrate 1 to the second surface 1b of substrate 1 through the side surface 1c of substrate 1. For the convenience of description, the side surface 1c where the connection leads 2 are located is collectively referred to as the selected side surface 1cc hereinafter.

It will be noted that, in a case where the substrate 1 includes a plurality of side surfaces 1c, the present disclosure does not limit the structures of other side surfaces 1c (i.e., the side surfaces 1c other than the selected side surface 1cc) in the plurality of side surfaces 1c. For example, in a case where the display panel 10 is a rectangular structure, the display panel 10 has four side surfaces 1c. For example, the four side surfaces 1c of the substrate 1 may all be selected side surfaces 1cc. For another example, as shown in FIGS. 2 and 3, one side surface 1c (e.g., the side surface 1c to which the plurality of first electrodes 4 in FIGS. 2 and 3 are proximate) in the four side surfaces 1c of the backplate 1 is the selected side surface 1cc, and the structures of the other three side surfaces 1c are not limited.

An end of each of the plurality of connection leads 2 is connected to a first electrode 4 located on the first surface 1a of the substrate 1, and another end of each of the plurality of connection leads 2 is connected to the circuit board 20 located on the second surface 1b of the substrate 1. In this way, it is possible to transfer a bonding region of the display panel 10 to the second surface 1b of the display panel 10, and make the circuit board 20 electrically connected to the first surface 1a of the display panel 10 through the plurality of connection leads 2, so as to control the display panel 10 to display, so that an area of the peripheral region AN of the display panel 10 is reduced, which is conducive to improving the screen-to-body ratio of the display panel 10.

Furthermore, the screen-to-body ratio of the display apparatus 100 including the display panel 10 may also be improved, which is conducive to achieving a narrow frame of the display apparatus 100 and improving the display effect of the display apparatus 100.

Furthermore, in a case where the tiled display apparatus 1000 includes a plurality of display panels 10, in an example where the peripheral region AN of the display panel 10 is located on a side of the display region AA of the display panel 10, as shown in FIG. 1, the plurality of display panels 10 are arranged in multiple rows in the first direction X and in multiple rows in the second direction Y. The peripheral regions AN of the display panels 10 are all arranged along the first direction X in the plurality of display panels 10 tiled together. In this way, there is basically no tiling gap in the first direction X between two adjacent display panels 10 in the plurality of display panels 10 arranged in a row in the first direction X, and there is a tiling gap between two adjacent display panels 10 in the plurality of display panels 10 arranged in a row in the second direction Y. That is to say, a dimension of the tiling gap between two adjacent display panels 10 in the plurality of display panels 10 arranged in a row in the first direction X is less than a dimension of the tiling gap between two adjacent display panels 10 in the plurality of display panels 10 arranged in a row in the second direction Y.

When the tiled display apparatus 1000 is viewed, since the peripheral regions AN of the display panels 10 have a small area, the dimension of the tiling gap between two adjacent display panels 10 in the plurality of display panels 10 arranged in a row in the second direction Y is also lesser, and the tiling gap between two adjacent display panels 10 is difficult to be found by the eyes within the viewing distance, so that the display images of the tiled display apparatus 1000 are relatively complete and may present a good display effect.

In some embodiments, with continued reference to FIG. 3, the display panel 10 further includes a protective layer 5. The protective layer 5 covers the plurality of connection leads 2. The protective layer 5 is disposed on a side of the plurality of connection leads 2 away from the substrate 1.

It will be noted that if portions of the plurality of connection leads 2 located on the second surface 1b of the substrate 1 are required to be exposed to bond to the circuit board 20, it is necessary to avoid a case where the protective layer 5 covers portions of the connection leads 2 to be connected with the circuit board 20. In addition to the above case, an area of an orthogonal projection of the protective layer 5 on any surface (e.g., the first surface 1a or the second surface 1b) of the display panel 10 is usually equal to or greater than areas of orthogonal projections of the connection leads 2 on any surface (e.g., the first surface 1a or the second surface 1b) of the display panel 10.

The protective layer 5 may protect the plurality of connection leads 2 and play a role of electrical insulation and water-oxygen corrosion resistance, so as to prevent the plurality of connection leads 2 from external damage that may cause problems such as peeling, disconnection, and oxidation.

For example, the protective layer 5 may be made of an insulating material with high corrosion resistance and high adhesion. For example, the protective layer 5 may be made of adhesive materials.

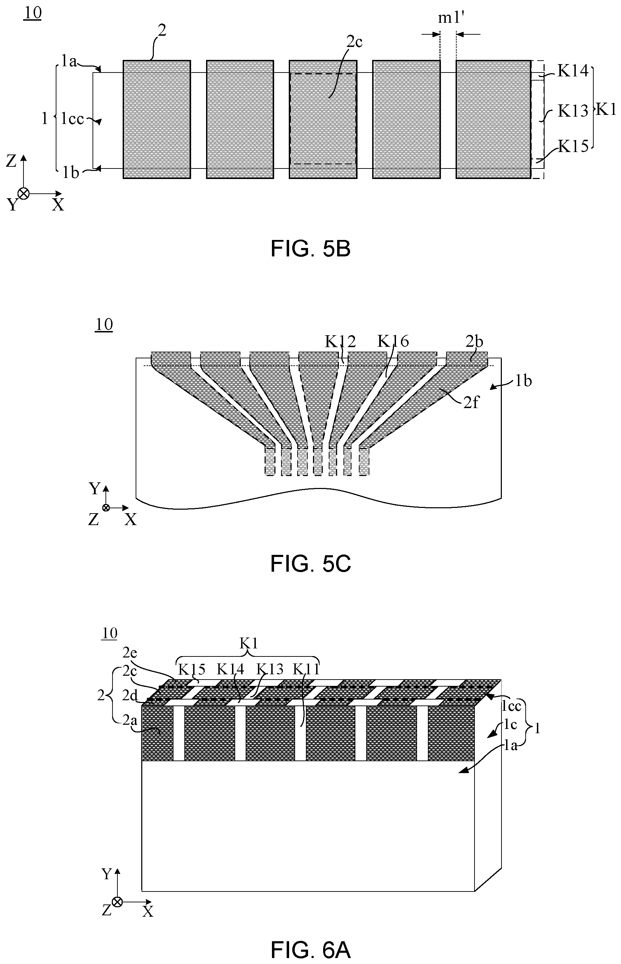

As shown in FIGS. 5A, 5B and 5C, FIGS. 5A, 5B and 5C each are a diagram showing a structure of the display panel 10, in accordance with some embodiments of the present disclosure, a depression region K1 is disposed between two adjacent connection leads 2, so as to separate the adjacent connection leads 2. On this basis, the protective layer 5 may also be filled in a plurality of depression regions K1, so as to ensure that adjacent connection leads 2 are insulated from each other.

The depression region K1 will be described in detail below.

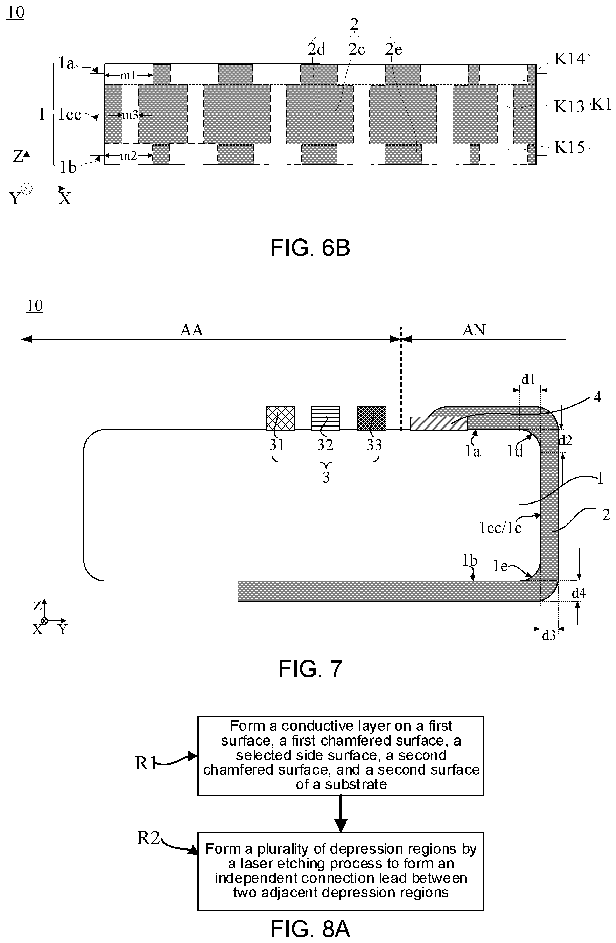

In some embodiments, as shown in FIGS. 5A, 5B, 5C, 6A and 6B, FIGS. 6A and 6B each are a diagram showing a structure of the display panel 10, in accordance with some embodiments of the present disclosure. The display panel 10 includes a plurality of depression regions K1. The connection leads 2 and the depression regions K1 are alternately arranged in the first direction X. Each depression region K1 extends from the first surface 1a to the second surface 1b through the selected side surface 1cc.

The depression region K1 includes a first depression sub-region K11 located on the first surface 1a of the substrate 1, a second depression sub-region K12 located on the second surface 1b of the substrate 1, a side depression sub-region K13 located on the selected side surface 1cc of the substrate 1, a first transition depression sub-region K14 connecting the first depression sub-region K11 and the side depression sub-region K13, and a second transition depression sub-region K15 connecting the second depression sub-region K12 and the side depression sub-region K13. Each first depression sub-region K11 and each second depression sub-region K12 extend in the second direction Y, and each side depression sub-region K13 extends in the third direction Z.

It will be noted that FIGS. 5A, 5B, 5C, 6A and 6B illustrate an example in which the first transition depression sub-region K14 and the second transition depression sub-region K15 are both located on the selected side surface 1cc of the substrate 1. However, the arrangement positions of the first transition depression sub-region K14 and the second transition depression sub-region K15 are not limited thereto. For example, the first transition depression sub-region K14 may also be located on the first surface 1a of the substrate 1; alternatively, a portion of the first transition depression sub-region K14 may be located on the selected side surface 1cc of the substrate 1, and another portion of the first transition depression sub-region K14 may be located on the first surface 1a of the substrate 1. The second transition depression sub-region K15 may also be located on the second surface 1b of the substrate 1; alternatively, a portion of the second transition depression sub-region K15 may be located on the selected side surface 1cc of the substrate 1, and another portion of the second transition depression sub-region K15 may be located on the second surface 1b of the substrate 1.

In some embodiments, with continued reference to FIGS. 5C, 9C and 14, the depression region K1 includes a fan-out depression sub-region K16 located on the second surface 1b of the substrate 1. The fan-out depression sub-region K16 is connected to the second depression sub-region K12 and is located on a side of the second depression sub-region K12 away from the selected side surface 1cc.

For example, with continued reference to FIG. 5C, an extending direction of the fan-out depression sub-region K16 intersects with an extending direction of the second depression sub-region K12, and ends of the plurality of fan-out depression sub-regions K16 away from the second depression sub-regions K12 are converged inward.

With continued reference to FIGS. 5A, 5B, 5C, 6A and 6B, each connection lead 2 includes a first lead segment 2a located between two adjacent first depression sub-regions K11, a second lead segment 2b located between two adjacent second depression sub-regions K12, a side lead segment 2c located between two adjacent side depression sub-regions K13, a first transition lead segment 2d located between two adjacent first transition depression sub-regions K14, a second transition lead segment 2e located between two adjacent second transition depression sub-regions K15, and a fan-out lead segment 2f located between two adjacent fan-out depression sub-regions K16. The first lead segment 2a, the first transition lead segment 2d, the side lead segment 2c, the second transition lead segment 2e, the second lead segment 2b and the fan-out lead segment 2f are connected in sequence, and ends of the plurality of fan-out lead segments 2f away from the selected side surface 1cc are converged inward.

It may be understood that since the connection lead 2 is located between two adjacent depression regions K1, that is, the depression region K1 separates two adjacent connection leads 2, a dimension of the depression region K1 in the first direction X is the same as a distance between the two connection leads 2 on two sides of the depression region K1. For example, a dimension of the first transition depression sub-region K14 of the depression region K1 in the first direction X is the same as a distance between the two first transition lead segments 2d on two sides of the first transition depression sub-region K14. A dimension of the second transition depression sub-region K15 of the depression region K1 in the first direction X is also the same as a distance between the two first transition lead segments 2e on two sides of the second transition depression sub-region K15.

For example, the dimension of the depression region K1 in the first direction X is greater than or equal to 25 µm, which is conducive to reducing the probability of short circuit between the connection leads 2 on two sides of the depression region K1.

For example, with continued reference to FIG. 4B, the dimension M_{K1} of the depression region K1 in the first direction X is less than or equal to 70% of a distance M₄ between two first electrodes 4 adjacent to the depression region K1.

In some embodiments, with continued reference to FIGS. 4A and 4B, a minimum distance between the first insulating sub-layer 62 and the first border 1aa is c1, a distance between an end portion of the connection lead 2 located on the first surface 1a and the first border 1aa is c2, a distance between an end portion of the depression region K1 proximate to the display region AA of the display panel 10 and the first border 1aa is c3, a distance between a border of the third opening 632 proximate to the display region AA of the display panel 10 and the first border 1aa is c4, and a distance between a border of the first electrode 4 proximate to the display region AA of the display panel 10 and the first border 1aa is c5.

For example, as shown in FIG. 4A, c1 ≤ c3 ≤ c2 ≤ c4 ≤ c5. For example, c1 = c3 < c2 < c4 < c5.

Alternatively, as shown in FIG. 4B, c1 ≤ c2 ≤ c3 ≤ c4 ≤ c5. For example, c1 < c2 < c3 < c4 < c5.

In some embodiments, with continued reference to FIGS. 5A, 5B, 5C, 6A and 6B, the dimension of the first transition depression sub-region K14 in the first direction X is greater than or equal to a dimension of the side depression sub-region K13 in the first direction X; and/or, the dimension of the second transition depression sub-region K15 in the first direction X is greater than or equal to the dimension of the side depression sub-region K13 in the first direction X.

For example, as shown in FIGS. 5A, 5B and 5C, dimensions of the first depression sub-region K11, the side depression sub-region K13, the first transition depression sub-region K14 and the second transition depression sub-region K15 in the first direction X are same and are all m1'. That is to say, distances between two adjacent first lead segments 2a, between two adjacent side lead segments 2c, between two adjacent first transition lead segments 2d and between two adjacent second transition lead segments 2e are also same, and are all m1'.

For example, as shown in FIGS. 6A and 6B, FIGS. 6A and 6B each are a diagram showing a structure of the display panel 10, in accordance with some embodiments of the present disclosure. The dimension m1 of the first transition depression sub-region K14 in the first direction X is greater than the dimension m3 of the side depression sub-region K13 in the first direction X.

The dimension m1 of the first transition depression sub-region K14 in the first direction X is set to be greater than the dimension m3 of the side depression sub-region K13 in the first direction X. That is to say, the dimension of the first transition depression sub-region K14 in the first direction X is increased.

The first transition depression sub-region K14 separates the first transition lead segments 2d of two adjacent connection leads 2, that is, the dimension of the first transition depression sub-region K14 in the first direction X is the same as the distance between two first transition lead segments 2d on two sides of the first transition depression sub-region K14, and both are m1. Therefore, the dimension m1 of the first transition depression sub-region K14 in the first direction X is increased, which may be equivalent to that the distance m1 between the two first transition lead segments 2d on two sides of the first transition depression sub-region K14 is increased. Since the distance m1 between the two first transition lead segments 2d on two sides of the first transition depression sub-region K14 increases, when the first lead segment 2a of the connection lead 2 located on the first surface 1a is connected to the side lead segment 2c located on the selected side surface 1cc through the first transition lead segment 2d, the probability of misaligned connection among the first lead segment 2a, the first transition lead segment 2d and the side lead segment 2c of the connection lead 2 may be reduced, thereby ensuring the normal display of the display panel 10.

It will be noted that the "misaligned connection among the first lead segment 2a, the first transition lead segment 2d and the side lead segment 2c of the connection lead 2" means that the first lead segment 2a and the first transition lead segment 2d in a same connection lead 2 may be misaligned when they are connected to each other, and the first lead segment 2a will be connected to the first transition lead segment 2d of other connection lead 2 (e.g., the adjacent connection leads 2).

Moreover, the side lead segment 2c and the first transition lead segment 2d in a same connection lead 2 may be misaligned when they are connected to each other, and the side lead segment 2c may be connected to the first transition lead segment 2d of other connection lead 2 (e.g., the adjacent connection leads 2), which may easily cause the display panel 10 to fail to display normally.

The same or similar descriptions below regarding "misaligned connection among the first lead segment 2a, the first transition lead segment 2d and the side lead segment 2c of the connection lead 2" also follow this description, which will not be repeated.

In some embodiments, with continued reference to FIGS. 6A and 6B, the dimension m2 of the second transition depression sub-region K15 in the first direction X is greater than the dimension m3 of the side depression sub-region K13 in the first direction X.

The dimension m2 of the second transition depression sub-region K15 in the first direction X is set to be greater than the dimension m3 of the side depression sub-region K13 in the first direction X. That is to say, the dimension of the second transition depression sub-region K15 in the first direction X is increased.

It may be understood that the second transition depression sub-region K15 separates the second transition lead segments 2e of two adjacent connection leads 2, and the dimension of the second transition depression sub-region K15 in the first direction X is the same as the distance between the two second transition lead segments 2e on two sides of the second transition depression sub-region K15, and both are m2. Therefore, the dimension m2 of the second transition depression sub-region K15 in the first direction X is increased, which may be equivalent to that the distance m2 between the two second transition lead segments 2e on two sides of the second transition depression sub-region K15 is increased. Since the distance m2 between the two second transition lead segments 2e on two sides of the second transition depression sub-region K15 increases, when the second lead segment 2b of the connection lead 2 located on the second surface 1b is connected to the side lead segment 2c located on the selected side surface 1cc through the second transition lead segment 2e, the probability of misaligned connection among the second lead segment 2b, the second transition lead segment 2e and the side lead segment 2c of the connection lead 2 may be reduced, thereby ensuring the normal display of the display panel 10.

It will be noted that the "misaligned connection among the second lead segment 2b, the second transition lead segment 2e and the side lead segment 2c of the connection lead 2" means that the second lead segment 2b and the second transition lead segment 2e in a same connection lead 2 may be misaligned when they are connected to each other, and the second lead segment 2b will be connected to the second transition lead segment 2e of other connection lead 2 (e.g., the adjacent connection leads 2).

Alternatively, the side lead segment 2c and the second transition lead segment 2e in a same connection lead 2 may be misaligned when they are connected to each other, and the side lead segment 2c may be connected to the second transition lead segment 2e of other connection lead 2 (e.g., the adjacent connection leads 2), which may easily cause the display panel 10 to fail to display normally.

The same or similar descriptions below regarding "misaligned connection among the second lead segment 2b, the second transition lead segment 2e and the side lead segment 2c of the connection lead 2" also follow this description and will not be repeated.

In some embodiments, as shown in FIG. 7, FIG. 7 is a diagram showing a structure of the display panel 10, in accordance with some embodiments of the present disclosure. The substrate 1 further includes a first chamfered surface 1d and a second chamfered surface 1e. The first chamfered surface 1d connects the first surface 1a of the substrate 1 and the selected side surface 1cc of the substrate 1, and the second chamfered surface 1e connects the second surface 1b of the substrate 1 and the selected side surface 1cc of the substrate 1.

For example, the first chamfered surface 1d and the second chamfered surface 1e may be set as cambered surfaces or inclined surfaces. FIG. 7 illustrates an example in which the first chamfered surface 1d and the second chamfered surface 1e may be set as only cambered surfaces.

For example, in a case where the first chamfered surface 1d of the substrate 1 is a cambered surface, the first surface 1a may be smoothly transitioned from the first chamfered surface 1d to the selected side surface 1cc, or the selected side surface 1cc may be smoothly transitioned from the first chamfered surface 1d to the first surface 1a.

Similarly, in a case where the second chamfered surface 1e of the substrate 1 is also a cambered surface, the second surface 1b may be smoothly transitioned from the second chamfered surface 1e to the selected side surface 1cc, or the selected side surface 1cc may be smoothly transitioned from the second chamfered surface 1e to the second surface 1b.

For another example, in a case where the first chamfered surface 1d of the substrate 1 is an inclined surface, an included angle between the first chamfered surface 1d and the first surface 1a of the substrate 1 and an included angle between the first chamfered surface 1d and the selected side surface 1cc of the substrate 1 are both obtuse angles. The first surface 1a may be relatively smoothly transitioned from the first chamfered surface 1d to the selected side surface 1cc, or the selected side surface 1cc may be relatively smoothly transitioned from the first chamfered surface 1d to the first surface 1a.

Similarly, in a case where the second chamfered surface 1e of the substrate 1 is also an inclined surface, the second surface 1b may be relatively smoothly transitioned from the second chamfered surface 1e to the selected side surface 1cc, or the selected side surface 1cc may be relatively smoothly transitioned from the second chamfered surface 1e to the second surface 1b.

For example, as shown in FIG. 7, a dimension d1 of an orthogonal projection of the first chamfered surface 1d on a plane where the first surface 1a is located in the second direction Y is greater than or equal to 10 µm and less than or equal to 50 µm.

A dimension d2 of an orthogonal projection of the first chamfered surface 1d on a plane where the selected side surface 1cc is located in the third direction Z is greater than or equal to 10 µm and less than or equal to 50 µm.

A dimension d3 of an orthogonal projection of the second chamfered surface 1e on a plane where the second surface 1b is located in the second direction Y is greater than or equal to 10 µm and less than or equal to 50 µm.

A dimension d4 of an orthogonal projection of the second chamfered surface 1e on the plane where the selected side surface 1cc is located in the third direction Z is greater than or equal to 10 µm and less than or equal to 50 µm.

For example, the dimension d1 of the orthogonal projection of the first chamfered surface 1d on the plane where the first surface 1a is located in the second direction Y may be 10 µm, 20 µm, 30 µm, 40 µm or 50 µm.

The dimension d2 of the orthogonal projection of the first chamfered surface 1d on the plane where the selected side surface 1cc is located in the third direction Z may be 10 µm, 20 µm, 30 µm, 40 µm or 50 µm.

The dimension d3 of the orthogonal projection of the second chamfered surface 1e on the plane where the second surface 1b is located in the second direction Y may be 10 µm, 20 µm, 30 µm, 40 µm or 50 µm.

The dimension d4 of the orthogonal projection of the second chamfered surface 1e on the plane where the selected side surface 1cc is located in the third direction Z may be 10 µm, 20 µm, 30 µm, 40 µm or 50 µm.

For example, the dimension d1 of the orthogonal projection of the first chamfered surface 1d on the plane where the first surface 1a is located in the second direction Y may be the same as or different from the dimension d2 of the orthogonal projection of the first chamfered surface 1d on the plane where the selected side surface 1cc is located in the third direction Z. In a case where the dimension d1 of the orthogonal projection of the first chamfered surface 1d on the plane where the first surface 1a is located in the second direction Y is the same as the dimension d2 of the orthogonal projection of the first chamfered surface 1d on the plane where the selected side surface 1cc is located in the third direction Z, the first chamfered surface 1d has good symmetry.

The dimension d3 of the orthogonal projection of the second chamfered surface 1e on the plane where the second surface 1b is located in the second direction Y may be the same as or different from the dimension d4 of the orthogonal projection of the second chamfered surface 1e on the plane where the selected side surface 1cc is located in the third direction Z. In a case where the dimension d3 of the orthogonal projection of the second chamfered surface 1e on the plane where the second surface 1b is located in the second direction Y is the same as the dimension d4 of the orthogonal projection of the second chamfered surface 1e on the plane where the selected side surface 1cc is located in the third direction Z, the second chamfered surface 1e has good symmetry.

For example, in a case where the substrate 1 has the first chamfered surface 1d and the second chamfered surface 1e, the first transition depression sub-region K14 of the depression region K1 is disposed on at least the first chamfered surface 1d, and the second transition depression sub-region K15 of the depression region K1 is disposed on at least the second chamfered surface 1e.

It will be noted that the "the first transition depression sub-region K14 is disposed on at least the first chamfered surface 1d" means that the first transition depression sub-region K14 may be disposed on only the first chamfered surface 1d of the substrate 1, or may also extend to the first surface 1a of the substrate 1 and/or the selected side surface 1cc of the substrate 1. The "the second transition depression sub-region K15 is disposed on at least the second chamfered surface 1e" means that the second transition depression sub-region K15 may be disposed on only the second chamfered surface 1e of the substrate 1, or may also extend to the second surface 1b of the substrate 1 and/or the selected side surface 1cc of the substrate 1.

With continued reference to FIG. 7, in a case where the substrate 1 has the first chamfered surface 1d and the second chamfered surface 1e, each of the plurality of connection leads 2 extends from the first surface 1a of the substrate 1 to the second surface 1b of the substrate 1 through the first chamfered surface 1d of the substrate 1, the selected side surface 1cc of the substrate 1 and the second chamfered surface 1e of the substrate 1 in sequence. When the plurality of connection leads 2 pass through the first chamfered surface 1d, since the first surface 1a of the substrate 1 may be smoothly transitioned from the first chamfered surface 1d to the selected side surface 1cc, or the selected side surface 1cc may be smoothly transitioned from the first chamfered surface 1d to the first surface 1a, compared with a case where the first surface 1a is directly connected to the selected side surface 1cc (in this case, an included angle between the first surface 1a and the selected side surface 1cc is 90°), in the embodiments of the present disclosure, each of the plurality of connection leads 2 is subjected to less stress at a corner (i.e., the first chamfered surface 1d) between the first surface 1a and the selected side surface 1cc, thereby reducing the problem of lead breakage caused by excessive stress concentration. In this way, the plurality of connection leads 2 are difficult to break at the corner (i.e., the first chamfered surface 1d) between the first surface 1a and the selected side surface 1cc, thereby ensuring that the plurality of connection leads 2 may stably connect the first surface 1a and second surface 1b of the substrate 1 that are oppositely disposed, and improving the stability of the display panel 10.

Similarly, when the plurality of connection leads 2 pass through the second chamfered surface 1e, each of the plurality of connection leads 2 is subjected to small stress at a corner (i.e., the second chamfered surface 1e) between the second surface 1b and the selected side surface 1cc, thereby reducing the problem of lead breakage caused by excessive stress concentration. In this way, the plurality of connection leads 2 are difficult to break at the corner (i.e., the second chamfered surface 1e) between the second surface 1b and the selected side surface 1cc, thereby ensuring that the plurality of connection leads 2 may effectively connect the first surface 1a and second surface 1b of the substrate 1 that are oppositely disposed, and further improving the reliability of the display panel 10.

The process of manufacturing the plurality of connection leads 2 is described in detail below.

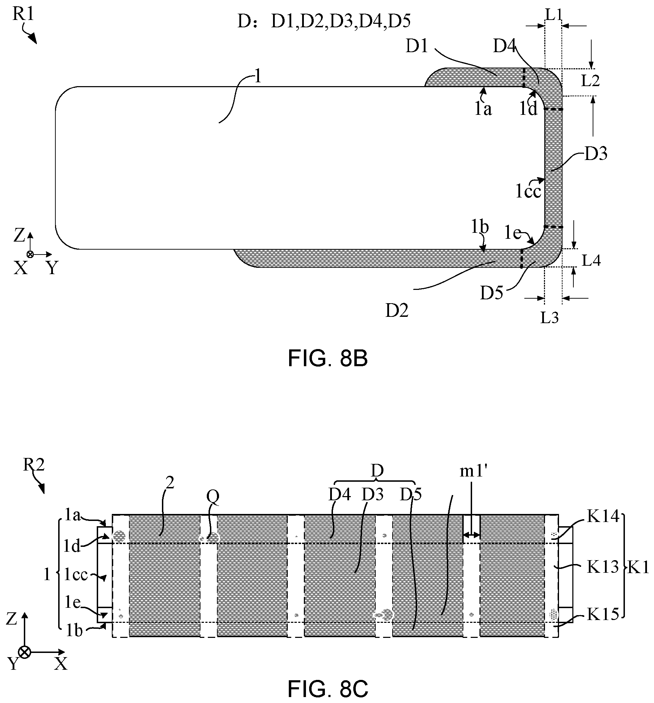

As shown in FIGS. 8A and 8B, FIG. 8A is a flow chart of a process of manufacturing the plurality of connection leads 2, in accordance with some embodiments of the present disclosure, and FIG. 8B is a diagram showing a structure of the display panel 10 corresponding to the step R1 in the process of manufacturing the plurality of connection leads 2 in FIG. 8A. The process of manufacturing the plurality of connection leads 2 includes the following steps.

In R1, as shown in FIG. 8B, a conductive layer D is formed on the first surface 1a, the first chamfered surface 1d, the selected side surface 1cc, the second chamfered surface 1e, and the second surface 1b of the substrate 1. The conductive layer D includes a first portion D1 located on the first surface 1a of the substrate 1, a fourth portion D4 located on the first chamfered surface 1d of the substrate 1, a third portion D3 located on the selected side surface 1cc of the substrate 1, a fifth portion D5 located on the second chamfered surface 1e of the substrate 1, and a second portion D2 located on the second surface 1b of the substrate 1. The first portion D1, the fourth portion D4, the third portion D3, the fifth portion D5, and the second portion D2 are connected in sequence.

In R2, the plurality of depression regions K1 are formed by a laser etching process to form an independent connection lead 2 between two adjacent depression regions K1.

It will be noted that FIGS. 8A and 8B illustrate only an example in which the substrate 1 includes the first chamfered surface 1d and the second chamfered surface 1e, and the fourth portion D4 of the conductive layer D is located on the first chamfered surface 1d of the substrate 1, and the fifth portion D5 of the conductive layer D is located on the second chamfered surface 1e of the substrate 1. In a case where the substrate 1 does not include the first chamfered surface 1d and the second chamfered surface 1e, the fourth portion D4 of the conductive layer D may be located on the first surface 1a or the selected side surface 1cc of the substrate 1, or, a portion of the fourth portion D4 of the conductive layer D may be located on the selected side surface 1cc of the substrate 1, and another portion of the fourth portion D4 of the conductive layer D may be located on the first surface 1a of the substrate 1. The fifth portion D5 of the conductive layer D may also be located on the second surface 1b or the selected side surface 1cc of the substrate 1, or a portion of the fifth portion D5 of the conductive layer D may be located on the selected side surface 1cc of the substrate 1, and another portion of the fifth portion D5 of the conductive layer D may be located on the second surface 1b of the substrate 1.

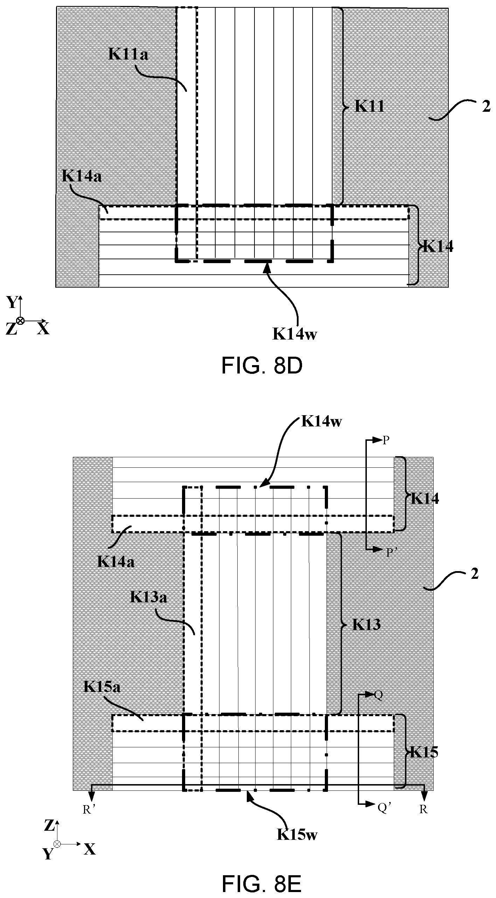

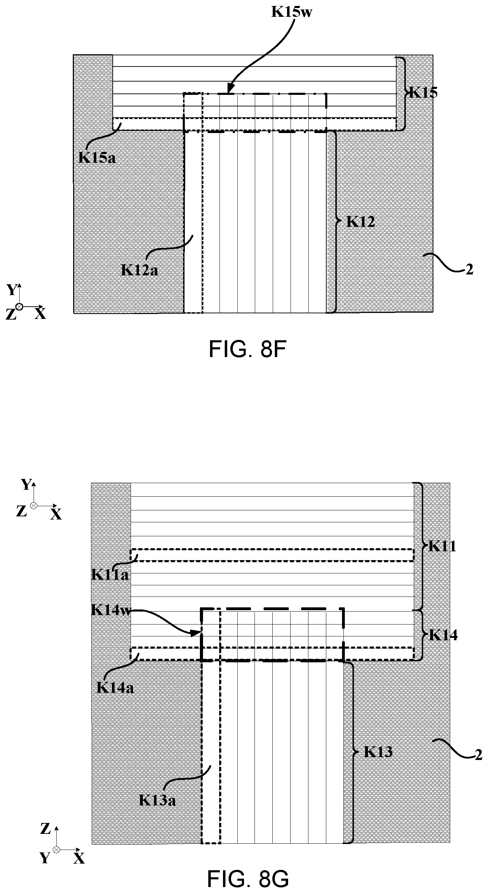

It may be understood that, a portion of the conductive layer is removed to form the depression regions K1 and the connection leads 2 by applying laser light to the conductive layer, and the depression region K1 includes groove(s) extending in a laser etching direction. For example, as shown in FIGS. 8D, 8E and 8F, when the first depression sub-region K11 is formed, a partial region of the conductive layer on the first surface 1a is irradiated by laser light, and the two move relative to each other in a specific direction (e.g., the second direction Y). The region of the conductive layer irradiated by the laser light is removed, and the remaining conductive layer on the first surface 1a forms the first lead segments of the plurality of connection leads. For example, during the laser etching process, it is possible to from groove(s) extending in the laser etching direction on the first surface by etching. That is to say, the first depression sub-region K11 includes a plurality of first grooves K11a arranged in parallel and extending in the second direction Y. When the second depression sub-region K12 is formed, a partial region of the conductive layer on the second surface 1b is irradiated by laser light, and the two move relative to each other in a specific direction (e.g., the second direction Y). The region of the conductive layer irradiated by the laser light is removed, and the remaining conductive layer on the second surface 1b forms the second lead segments of the plurality of connection leads. For example, during the laser etching process, it is possible to from groove(s) extending in the laser etching direction on the second surface by etching. That is to say, the second depression sub-region K12 includes a plurality of second grooves K12a arranged in parallel and extending in the second direction Y. When the side depression sub-region K13 is formed, a partial region of the conductive layer on the selected side surface 1cc is irradiated by laser light, and the two move relative to each other in a specific direction (e.g., the third direction Z). The region of the conductive layer irradiated by the laser light is removed, and the remaining conductive layer on the selected side surface 1cc forms the side lead segments of the plurality of connection leads. For example, during the laser etching process, it is possible to from groove(s) extending in the laser etching direction on the selected side surface by etching. That is to say, the side depression sub-region K13 includes a plurality of side grooves K13a arranged in parallel and extending in the third direction Z. In some examples, the first groove K11a extends to the first transition depression sub-region K14, the second groove K12a extends to the second transition depression sub-region K15, and the side groove K13a extends to the first transition depression sub-region K14 and the second transition depression sub-region K15.

For example, an electroplating process, an evaporation process, a silver adhesive pad printing process, a sputtering process (e.g., a multi-arc magnetron sputtering process) or a deposition process may be used to form the conductive layer D on the first surface 1a, the first chamfered surface 1d, the selected side surface 1cc, the second chamfered surface 1e and the second surface 1b of the substrate 1.

It may be understood that before the conductive layer D is formed by the deposition process, a mask is required to be disposed on the first surface 1a and the second surface 1b of the substrate 1 to cover the region where at least the pixel units P are located. Considering the alignment accuracy or tolerance, the mask also covers partial regions of the first electrodes 4 exposed by the third openings 632 and proximate to the pixel units P.

For example, a contour of the mask proximate to the border of the substrate 1 has the same shape as a contour 61 of the first insulating sub-layer 62 proximate to the border of the substrate 1.

For example, the first portion D1 of the conductive layer D located on the first surface 1a of the substrate 1 is in electrical contact with the first electrode(s) 4. For example, the first portion D1 of the conductive layer D may cover the plurality of first electrodes 4, so that the two have a large contact area.

In a case where the substrate 1 includes the first chamfered surface 1d and the second chamfered surface 1e, with continued reference to FIG. 8B, since the first chamfered surface 1d and the second chamfered surface 1e of the substrate 1 are cambered surfaces or inclined surfaces, the fourth portion D4 and the fifth portion D5 of the conductive layer D formed on the outside of the first chamfered surface 1d and the second chamfered surface 1e are conformal to the first chamfered surface 1d and the second chamfered surface 1e, respectively.

It may be understood that, since the fourth portion D4 of the conductive layer D is a cambered surface, there is a distance between some regions of a surface of the fourth portion D4 of the conductive layer D away from the substrate 1 in the second direction Y or the third direction Z. For example, in FIG. 8B, there is a distance L1 in the second direction Y and a distance L2 in the third direction Z between two regions selected from the surface of the fourth portion D4 of the conductive layer D away from the substrate 1.

Similarly, since the fifth portion D5 of the conductive layer D is a cambered surface, there is a distance between some regions of a surface of the fifth portion D5 of the conductive layer D away from the substrate 1 in the second direction Y or the third direction Z. For example, in FIG. 8B, there is a distance L3 in the second direction Y and a distance L4 in the third direction Z between two regions selected from the surface of the fifth portion D5 of the conductive layer D away from the substrate 1.

In a case where the depression regions K1 are formed by the laser etching process in the step R2, since the surfaces of the fourth portion D4 and the fifth portion D5 of the conductive layer D are not coplanar with surfaces of other regions of the conductive layer D, when the fourth portion D4 of the conductive layer D on the first chamfered surface 1d or the fifth portion D5 of the conductive layer D on the second chamfered surface 1e is etched, whether the laser light moves in the second direction Y on a plane having a specific distance from the first surface 1a or the second surface 1b of the substrate 1, or the laser light moves in the third direction Z on a plane having a specific distance from the selected side surface 1cc, the conductive patterns Q as shown in FIG. 8C may be residual due to the change of the defocus amount when the fourth portion D4 and the fifth portion D5 of the conductive layer D are etched, thereby causing the short circuit between subsequent adjacent connection leads 2.

It will be noted that in a case where the depression regions K1 are formed by the laser etching process in the step R2, and the substrate 1 does not include the first chamfered surface 1d and the second chamfered surface 1e, when the conductive layer D on the first surface 1a, the selected side surface 1cc and the second surface 1b of the substrate 1 is etched, the conductive layer D formed at a boundary of the first surface 1a and the selected side surface 1cc of the substrate 1 and at a boundary of the second surface 1b and the selected side surface 1cc of the substrate 1 is not at an absolute right angle due to the manufacturing process, and the fourth portion D4 and the fifth portion D5 of the conductive layer D both are cambered surfaces with a small radian, so that the etching residue problem caused by a difference in defocus amount may easily occur during the laser etching process.

On this basis, embodiments of the arrangement of the first transition depression sub-region K14 are firstly described below by considering an example in which the substrate 1 includes the first chamfered surface 1d and the second chamfered surface 1e.

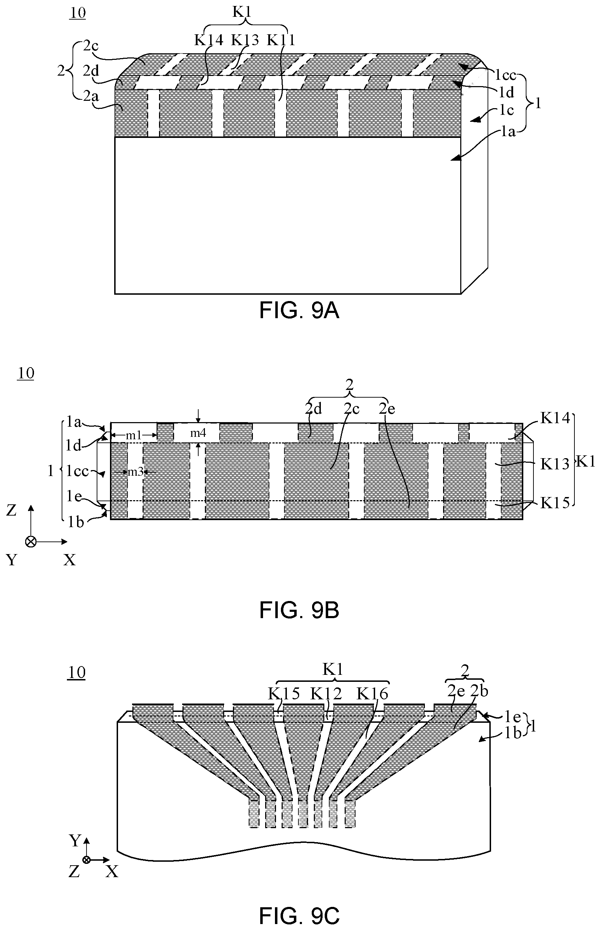

In some embodiments, as shown in FIGS. 9A, 9B, and 9C, FIGS. 9A, 9B, and 9C each are a diagram showing a structure of the display panel 10, in accordance with some embodiments of the present disclosure. The display panel 10 includes a plurality of depression regions K1, and the depression regions K1 extend from the first surface 1a to the second surface 1b through the first chamfered surface 1d, the selected side surface 1cc and the second chamfered surface 1e in sequence. The depression region K1 includes a first depression sub-region K11 located on the first surface 1a, a second depression sub-region K12 located on the second surface 1b, a side depression sub-region K13 located on the selected side surface 1cc, a first transition depression sub-region K14 located on the first chamfered surface 1d, and a second transition depression sub-region K15 located on the second chamfered surface 1e.

A connection lead 2 is disposed between two adjacent depression regions K1. The connection lead 2 includes a first lead segment 2a located on the first surface 1a, a second lead segment 2b located on the second surface 1b, a side lead segment 2c located on the selected side surface 1cc, a first transition lead segment 2d located on the first chamfered surface 1d, and a second transition lead segment 2e located on the second chamfered surface 1e.

With continued reference to FIGS. 8D and 8E, the first transition depression sub-region K14 includes a plurality of first transition grooves K14a arranged in parallel. An extending direction of the first transition grooves K14a has a first included angle with an extending direction of at least one of the first grooves K11a and the side grooves K13a. The first transition groove K14a crosses at least one of the first groove K11a and the side groove K13a to form a first grid-like depression portion K14W.

That is to say, the first groove K11a is not only located in the first depression sub-region K11, but also includes a portion extending to the first transition depression sub-region K14. And/or the side groove K13a is not only located in the side depression sub-region K13, but also includes a portion extending to the first transition depression sub-region K14. That is to say, the first transition groove K14a and the first groove K11a may cross each other to form the first grid-like depression portion K14W located in the first transition depression sub-region K14 (as shown in FIG. 8D); alternatively, the first transition groove K14a and the side groove K13a may cross each other to form the first grid-like depression portion K14W located in the first transition depression sub-region K14 (as shown in FIGS. 8E and 8G); alternatively, the first transition groove K14a, the first groove K11a and the side groove K13a may cross each other to form the first grid-like depression portion K14W located in the first transition depression sub-region K14.

It will be noted that FIGS. 8D and 8E illustrate an example in which the extending direction of the first transition grooves K14a is perpendicular to only the extending direction of the first grooves K11a and/or the extending direction of the side grooves K13a. For example, the first groove K11a extends in the second direction Y, the side groove K13a extends in the third direction Z, and the first transition groove K14a extends in the first direction X.

As shown in FIG. 8G, the first grooves K11a extend in the first direction X, the side grooves K13a extend in the third direction Z, and the plurality of first transition grooves included by the first transition grooves K14a also extend in the first direction X. In this case, the first transition grooves K14a and the side grooves K13a cross each other to form the first grid-like depression portion K14W located in the first transition depression sub-region K14. The plurality of first transition grooves K14a may be formed by laser etching. For example, at least one of the plurality of first transition grooves K14a may be located on the first surface, at least one of the plurality of first transition grooves K14a may be located on the selected side surface. The plurality of first transition grooves K14a located on the first surface 1a of the substrate 1 are arranged in the second direction Y, and the plurality of first transition grooves K14a located on the selected side surface 1cc of the substrate 1 are arranged in the third direction Z.

The extending direction of the plurality of first transition grooves K14a in the first transition depression sub-region K14 has the first included angle with the extending direction of at least one of the first grooves K11a and the side grooves K13a. That is to say, an etching direction when the first transition groove K14a is formed is different from an etching direction when at least one of the first groove K11a and the side groove K13a is formed. Therefore, it is necessary to etch the fourth portion D4 of the conductive layer D twice in different etching directions, so as to form the first grid-like depression portion K14W in the first transition depression sub-region K14, which may reduce the probability that the conductive pattern Q is residual in the first transition depression sub-region K14.

For example, a dimension of the first transition depression sub-region K14 in the first direction X may be the same as a dimension of the side depression sub-region K13 in the first direction X. Alternatively, as shown in FIG. 9B, the dimension m1 of the first transition depression sub-region K14 in the first direction X may also be greater than the dimension m3 of the side depression sub-region K13 in the first direction X.

In a case where the dimension m1 of the first transition depression sub-region K14 in the first direction X is greater than the dimension m3 of the side depression sub-region K13 in the first direction X, the dimension of the first transition depression sub-region K14 in the first direction X is increased. In one aspect, it may be understood that the first transition depression sub-region K14 separates the first transition lead segments 2d of two adjacent connection leads 2, the dimension of the first transition depression sub-region K14 in the first direction X is the same as a distance between the two first transition lead segments 2d on two sides of the first transition depression sub-region K14, and both are m1. Therefore, the dimension m1 of the first transition depression sub-region K14 in the first direction X is increased, which may be equivalent to that the distance m1 between the two first transition lead segments 2d on two sides of the first transition depression sub-region K14 is increased. In a case where the distance m1 between the two first transition lead segments 2d on two sides of the first transition depression sub-region K14 increases, even if there are one or more residual conductive patterns Q in the first transition depression sub-region K14, it is also possible to reduce the probability of short circuit caused by the one or more residual conductive patterns Q being connected to the first transition lead segments 2d of the connection leads 2 on two sides of the one or more residual conductive patterns Q, which is conducive to improving the stability of the display panel 10.

In another aspect, since the distance m1 between the two first transition lead segments 2d on two sides of the first transition depression sub-region K14 increases, when the first lead segment 2a of the connection lead 2 located on the first surface 1a is connected to the side lead segment 2c located on the selected side surface 1cc through the first transition lead segment 2d, the probability of misaligned connection among the first lead segment 2a, the first transition lead segment 2d and the side lead segment 2c of the connection lead 2 may be reduced, thereby ensuring the normal display of the display panel 10.

For example, as shown in FIG. 9B, a dimension m4 of an orthogonal projection of the first transition depression sub-region K14 on a plane where the selected side surface 1cc is located in the third direction Z is greater than or equal to 10 µm and less than or equal to 50 µm.

For example, the dimension m4 of the orthogonal projection of the first transition depression sub-region K14 on the plane where the selected side surface 1cc is located in the third direction Z may be 10 µm, 20 µm, 30 µm, 40 µm or 50 µm.

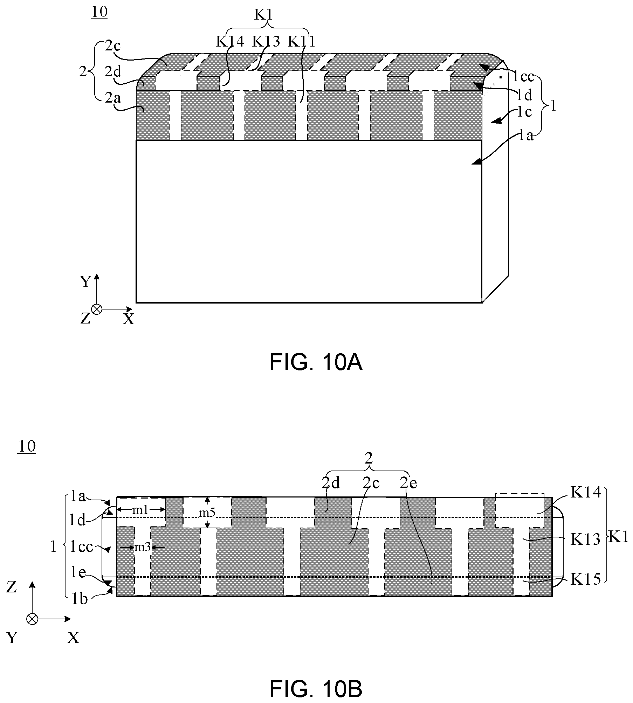

In some embodiments, as shown in FIGS. 10A and 10B, FIGS. 10A and 10B are a diagram showing a structure of the display panel 10, in accordance with some embodiments of the present disclosure. Based on the embodiment shown in FIGS. 9A, 9B and 9C, in the embodiment shown in FIGS. 10A and 10B, the first transition depression sub-region K14 extends to the selected side surface 1cc of the substrate 1.

When the fourth portion D4 of the conductive layer D on the first chamfered surface 1d is etched by a laser etching process to obtain the first transition depression sub-region K14, and the third portion D3 of the conductive layer D on the selected side surface 1cc is etched by a laser etching process to obtain the side depression sub-region K13, the first transition depression sub-region K14 is extended to the selected side surface 1cc, which is conducive to fully etching the boundary between the first chamfered surface 1d and the selected side surface 1cc of the substrate 1, reducing the probability of short circuit of the connection leads 2, and ensuring the normal display of the display panel 10.

For example, the dimension of the first transition depression sub-region K14 in the first direction X may be the same as the dimension of the side depression sub-region K13 in the first direction X. Alternatively, as shown in FIG. 10B, the dimension m1 of the first transition depression sub-region K14 in the first direction X may also be greater than the dimension m3 of the side depression sub-region K13 in the first direction X.

In a case where the dimension m1 of the first transition depression sub-region K14 in the first direction X is greater than the dimension m3 of the side depression sub-region K13 in the first direction X, and the first transition depression sub-region K14 extends to the selected side surface 1cc of the substrate 1, in the first direction X, in two connection leads 2 on two sides of the first transition depression sub-region K14, a distance between the first transition lead segments 2d located on the first chamfered surface 1d, and a distance between partial regions (i.e., portions of the side lead segments 2c on two sides of the first transition depression sub-region K14 in the first direction X) of the side lead segments 2c located on the selected side surface 1cc are also m1. When the side lead segment 2c and the first transition lead segment 2d in a same connection lead 2 are connected with each other, the probability of misaligned connection between the first transition lead segment 2d and the side lead segment 2c of the connection lead 2 may be further reduced, thereby ensuring the normal display of the display panel 10.

For example, as shown in FIG. 10B, a dimension m5 of an orthogonal projection of the first transition depression sub-region K14 on the plane where the selected side surface 1cc is located in the third direction Z is greater than or equal to 60 µm.

For example, the dimension m5 of the orthogonal projection of the first transition depression sub-region K14 on the plane where the selected side surface 1cc is located in the third direction Z may be 60 µm, 63 µm, 66 µm, 69 µm, 73 µm, 80 µm, 88 µm, 90 µm, 93 µm or 100 µm.

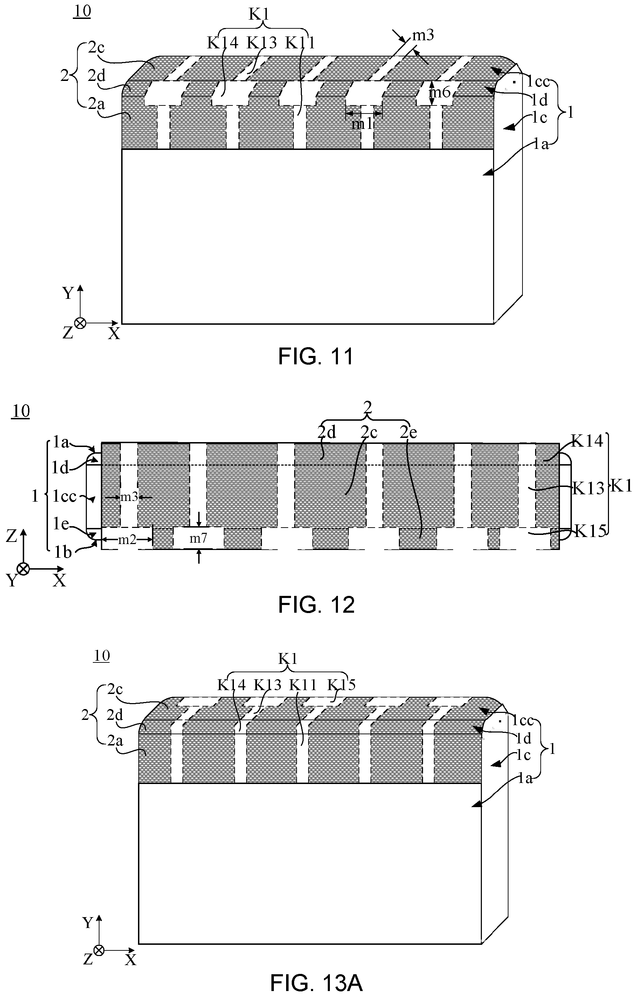

In some embodiments, as shown in FIG. 11, FIG. 11 is a diagram showing a structure of the display panel 10, in accordance with some embodiments of the present disclosure. Based on the embodiment shown in FIGS. 9A, 9B and 9C, in the embodiment shown in FIG. 11, the first transition depression sub-region K14 extends to the first surface 1a of the substrate 1.

It will be noted that FIG. 11 exemplarily illustrates that the first transition depression sub-region K14 extends to the first surface 1a of the substrate 1 by considering the embodiment shown in FIGS. 9A, 9B and 9C as an example. However, the embodiments of the present disclosure are not limited thereto. For example, the first transition depression sub-region K14 may also be set to extend to the first surface 1a of the substrate 1 based on the embodiment shown in FIGS. 10A and 10B. That is to say, the first transition depression sub-region K14 may extend to both the selected side surface 1cc and the first surface 1a of the substrate 1.

By making the first transition depression sub-region K14 extend to the first surface 1a of the substrate 1, when the fourth portion D4 of the conductive layer D on the first chamfered surface 1d is etched by a laser etching process to obtain the first transition depression sub-region K14, and the first portion D1 of the conductive layer D on the first surface 1a is etched by a laser etching process to obtain the first depression sub-region K11, the first transition depression sub-region K14 is extended to the first surface 1a, which is conducive to fully etching the boundary between the first chamfered surface 1d and the first surface 1a of the substrate 1, reducing the probability of short circuit of the connection leads 2, and ensuring the normal display of the display panel 10.

For example, the dimension of the first transition depression sub-region K14 in the first direction X may be the same as the dimension of the side depression sub-region K13 in the first direction X. Alternatively, as shown in FIG. 11, the dimension m1 of the first transition depression sub-region K14 in the first direction X may also be greater than the dimension m3 of the side depression sub-region K13 in the first direction X. The first direction X is perpendicular to an extending direction of the depression region K1.

In a case where the dimension m1 of the first transition depression sub-region K14 in the first direction X is greater than the dimension m3 of the side depression sub-region K13 in the first direction X, and the first transition depression sub-region K14 extends to the first surface 1a, in the first direction X, in two connection leads 2 on two sides of the first transition depression sub-region K14, a distance between the first transition lead segments 2d located on the first chamfered surface 1d, and a distance between partial regions (i.e., portions of the first lead segments 2a on two sides of the first transition depression sub-region K14 in the first direction X) of the first lead segments 2a located on the first surface 1a are also m1. When the first lead segment 2a and the first transition lead segment 2d in a same connection lead 2 are connected with each other, the probability of misalignment connection between the first transition lead segment 2d and the first lead segment 2a of the connection lead 2 may be further reduced, thereby ensuring normal display of the display panel 10.

For example, as shown in FIG. 11, a dimension m6 of an orthogonal projection of the first transition depression sub-region K14 on a plane where the first surface 1a is located in the second direction Y is greater than or equal to 60 µm.

For example, the dimension m6 of the orthogonal projection of the first transition depression sub-region K14 on the plane where the first surface 1a is located in the second direction Y may be 60 µm, 63 µm, 66 µm, 69 µm, 73 µm, 80 µm, 88 µm, 90 µm, 93 µm or 100 µm.

Next, embodiments of the arrangement of the second transition depression sub-region K15 are described.

In some embodiments, with continued reference to FIGS. 8E and 8F, the second transition depression sub-region K15 includes a plurality of second transition grooves K15a arranged in parallel. An extending direction of the second transition grooves K15a has a second included angle with an extending direction of at least one of the second grooves K12a and the side grooves K13a. The second transition groove K15a crosses at least one of the second groove K12a and the side groove K13a to form a second grid-like depression portion K15W.

That is to say, the second groove K12a is not only located in the second depression sub-region K12, but also includes a portion extending to the second transition depression sub-region K15. And/or, the side groove K13a is not only located in the side depression sub-region K13, but also includes a portion extending to the second transition depression sub-region K15. That is to say, the second transition groove K15a and the second groove K12a may cross each other to form the second grid-like depression portion K15W located in the second transition depression sub-region K15 (as shown in FIG. 8F); alternatively, the second transition groove K15a and the side groove K13a may cross each other to form the second grid-like depression portion K15W located in the second transition depression sub-region K15 (as shown in FIG. 8E); alternatively, the first transition groove K14a, the first groove K11a and the side groove K13a may cross each other to form the second grid-like depression portion K15W located in the second transition depression sub-region K15.

It will be noted that FIGS. 8E and 8F illustrate an example in which the extending direction of the second transition grooves K15a is perpendicular to only the extending direction of the second grooves K12a and/or the extending direction of the side grooves K13a. For example, the second grooves K12a extend in the second direction Y, the side grooves K13a extend in the third direction Z, and the second transition grooves K15a extend in the first direction X.

The plurality of second transition grooves K15a may be formed by laser etching. For example, a portion of the plurality of second transition grooves K15a are located on the first surface, and a portion of the plurality of second transition grooves K15a are located on the selected side surface. The plurality of second transition grooves K15a are arranged in the second direction Y on the second surface 1b of the substrate 1, and the plurality of second transition grooves K15a are arranged in the third direction Z on the selected side surface 1cc of the substrate 1.

The extending direction of the plurality of second transition grooves K15a in the second transition depression sub-region K15 has the second included angle with the extending direction of at least one of the first grooves K11a and the side grooves K13a. That is to say, an etching direction when the second transition groove K15a is formed is different from an etching direction when at least one of the second groove K12a and the side groove K13a is formed. Therefore, when the second transition depression sub-region K15 is formed, it is necessary to etch the fifth portion D5 of the conductive layer D twice in different etching directions, so as to form the second grid-like depression portion K15W, which may reduce the probability that the conductive pattern Q is residual in the second transition depression sub-region K15.

In some embodiments, as shown in FIG. 8E, the side groove K13a extends to the first transition depression sub-region K14 and the second transition depression sub-region K15, and a dimension of a portion of the side groove K13a extending to the first transition depression sub-region K14 is different from a dimension of a portion of the side groove K13a extending to the second transition depression sub-region K15. For example, the dimension of the portion of the side groove K13a extending to the first transition depression sub-region K14 is less than the dimension of the portion of the side groove K13a extending to the second transition depression sub-region K15. In this way, an area of the second grid-like depression portion K15W formed by the second transition grooves K15a and the side grooves K13a crossing each other is different from an area of the first grid-like depression portion K14W formed by the first transition grooves K14a and the side grooves K13a crossing each other.

For example, the second transition depression sub-region K15 is located on the second chamfered surface 1e of the substrate 1. A dimension of the second transition depression sub-region K15 in the first direction X may be the same as a dimension of the side depression sub-region K13 in the first direction X. Alternatively, as shown in FIG. 12, FIG. 12 is a diagram showing a structure of the display panel 10, in accordance with some embodiments of the present disclosure. The dimension m2 of the second transition depression sub-region K15 in the first direction X is greater than the dimension m3 of the side depression sub-region K13 in the first direction X. The first direction X is perpendicular to the extending direction of the depression region K1.

In a case where the dimension m2 of the second transition depression sub-region K15 in the first direction X is greater than the dimension m3 of the side depression sub-region K13 in the first direction X, the dimension of the second transition depression sub-region K15 in the first direction X is increased. In one aspect, since the distance m2 between two second transition lead segments 2e on two sides of the second transition depression sub-region K15 increases, when the second lead segment 2b of the connection lead 2 located on the second surface 1b is connected to the side lead segment 2c located on the limited side surface 1cc through the second transition lead segment 2e, the probability of misaligned connection among the second lead segment 2b, the second transition lead segment 2e and the side lead segment 2c of the connection lead 2 may be reduced, thereby ensuring the normal display of the display panel 10.

In another aspect, it may be understood that the second transition depression sub-region K15 separates the second transition lead segments 2e of two adjacent connection leads 2, the dimension of the second transition depression sub-region K15 in the first direction X is the same as a distance between two second transition lead segments 2e on two sides of the second transition depression sub-region K15, and both are m2. Therefore, the dimension m2 of the second transition depression sub-region K15 in the first direction X is increased, which may be equivalent to that the distance m2 between the two second transition lead segments 2e on two sides of the second transition depression sub-region K15 is increased. In a case where the distance m2 between the two second transition lead segments 2e on two sides of the second transition depression sub-region K15 increases, even if there are one or more residual conductive patterns Q in the second transition depression sub-region K15, the probability of short circuit caused by the one or more residual conductive patterns Q being connected to the second transition lead segments 2e of the connection leads 2 on two sides of the one or more residual conductive patterns Q may be reduced, which is conducive to improving the stability of the display panel 10.

For example, as shown in FIG. 12, a dimension m7 of an orthogonal projection of the second transition depression sub-region K15 on the plane where the selected side surface 1cc is located in the third direction Z is greater than or equal to 10 µm and less than or equal to 50 µm.

For example, the dimension m7 of the orthogonal projection of the second transition depression sub-region K15 on the plane where the selected side surface 1cc is located in the third direction Z may be 10 µm, 20 µm, 30 µm, 40 µm or 50 µm.

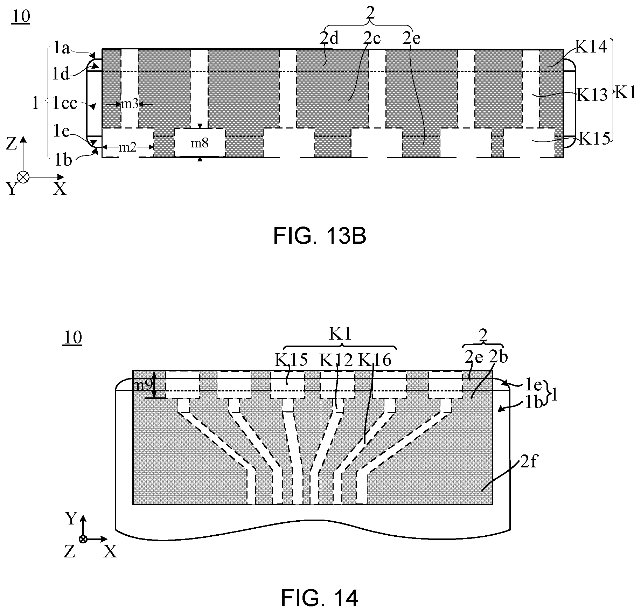

In some embodiments, as shown in FIGS. 13A and 13B, FIGS. 13A and 13B are a diagram showing a structure of the display panel 10, in accordance with some embodiments of the present disclosure. Based on the embodiment shown in FIG. 12, in the embodiment shown in FIGS. 13A and 13B, the second transition depression sub-region K15 extends to the selected side surface 1cc of the substrate 1.

When the fifth portion D5 of the conductive layer D on the second chamfered surface 1e is etched by a laser etching process to obtain the second transition depression sub-region K15, and the third portion D3 of the conductive layer D on the selected side surface 1cc is etched by a laser etching process to obtain the side depression sub-region K13, the second transition depression sub-region K15 is extended to the selected side surface 1cc, which is conducive to fully etching the boundary between the second chamfered surface 1e and the selected side surface 1cc of the substrate 1, reducing the probability of short circuit of the connection leads 2, and ensuring the normal display of the display panel 10.

For example, the dimension of the second transition depression sub-region K15 in the first direction X may be the same as the dimension of the side depression sub-region K13 in the first direction X. Alternatively, as shown in FIG. 13B, the dimension m2 of the second transition depression sub-region K15 in the first direction X may also be greater than the dimension m3 of the side depression sub-region K13 in the first direction X. The first direction X is perpendicular to the extending direction of the depression region K1.

In a case where the dimension m2 of the second transition depression sub-region K15 in the first direction X is greater than the dimension m3 of the side depression sub-region K13 in the first direction X, and the second transition depression sub-region K15 extends to the selected side surface 1cc, in the first direction X, in two connection leads 2 on two sides of the second transition depression sub-region K15, a distance between the second transition lead segments 2e located on the second chamfered surface 1e, and a distance between partial regions (i.e., portions of the side lead segments 2c on two sides of the second transition depression sub-region K15 in the first direction X) of the side lead segments 2c located on the selected side surface 1cc are also m2. When the side lead segment 2c and the second transition lead segment 2e in a same connection lead 2 are connected with each other, the probability of misaligned connection between the second transition lead segment 2e and the side lead segment 2c of the connection lead 2 may be further reduced, thereby ensuring the normal display of the display panel 10.

For example, as shown in FIG. 13B, a dimension m8 of an orthogonal projection of the second transition depression sub-region K15 on the plane where the selected side surface 1cc is located in the third direction Z is greater than or equal to 60 µm.

For example, the dimension m8 of the orthogonal projection of the second transition depression sub-region K15 on the plane where the selected side surface 1cc is located in the third direction Z may be 60 µm, 63 µm, 66 µm, 69 µm, 73 µm, 80 µm, 88 µm, 90 µm, 93 µm or 100 µm.

In some embodiments, as shown in FIG. 14, FIG. 14 is a diagram showing a structure of the display panel 10, in accordance with some embodiments of the present disclosure. Based on the embodiment shown in FIG. 12, in the embodiment shown in FIG. 14, the second transition depression sub-region K15 extends to the second surface 1b of the substrate 1.

It will be noted that FIG. 14 exemplarily illustrates that the second transition depression sub-region K15 extends to the second surface 1b of the substrate 1 by considering the embodiment shown in FIG. 12 as an example. However, the embodiments of the present disclosure are not limited thereto. For example, the second transition depression sub-region K15 may be set to extend to the second surface 1b of the substrate 1 based on the embodiment shown in FIGS. 13A and 13B. That is to say, the second transition depression sub-region K15 may extend to both the selected side surface 1cc and the second surface 1b of the substrate 1.

By making the second transition depression sub-region K15 extend to the second surface 1b of the substrate 1, when the fifth portion D5 of the conductive layer D on the second chamfered surface 1e is etched by a laser etching process to obtain the second transition depression sub-region K15, and the second portion D2 of the conductive layer D on the second surface 1b is etched by a laser etching process to obtain the second depression sub-region K12, the second transition depression sub-region K15 is extended to the second surface 1b, which is conducive to fully etching the boundary between the second chamfered surface 1e and the second surface 1b of the substrate 1, reducing the probability of short circuit of the connection leads 2, and ensuring the normal display of the display panel 10.

For example, in a case where the dimension m2 of the second transition depression sub-region K15 in the first direction X is greater than the dimension m3 of the side depression sub-region K13 in the first direction X, and the second transition depression sub-region K15 extends to the second surface 1b, in the first direction X, in two connection leads 2 on two sides of the second transition depression sub-region K15, a distance between the second transition lead segments 2e located on the second chamfered surface 1e, and a distance between partial regions (i.e., portions of the second lead segment 2b on two sides of the second transition depression sub-region K15 in the first direction X) of the second lead segments 2b located on the second surface 1b are also m2. When the second lead segment 2b and the second transition lead segment 2e in a same connection lead 2 are connected with each other, the probability of misaligned connection between the second transition lead segment 2e and the second lead segment 2b of the connection lead 2 may be further reduced, thereby ensuring normal display of the display panel 10.

For example, as shown in FIG. 14, a dimension m9 of an orthogonal projection of the second transition depression sub-region K15 on a plane where the second surface 1b is located in the second direction Y is greater than or equal to 60 µm.

For example, the dimension m9 of the orthogonal projection of the second transition depression sub-region K15 on the plane where the second surface 1b is located in the second direction Y may be 60 µm, 63 µm, 66 µm, 69 µm, 73 µm, 80 µm, 88 µm, 90 µm, 93 µm or 100 µm.

Although some embodiments of the present disclosure are described herein in combination with FIGS. 9A to 14, the above description is exemplary and not exhaustive. Therefore, some embodiments of the present disclosure are not limited to the disclosed embodiments. Many modifications and variations will be apparent to those of ordinary skill in the art without deviating from the scope of the embodiments described above. For example, the embodiments of the arrangement of the first transition depression sub-region K14 shown in FIGS. 9A to 11 and the embodiments of the arrangement of the second transition depression sub-region K15 shown in FIGS. 12 to 14 may be optionally combined. That is to say, the first transition depression sub-region K14 and the second transition depression sub-region K15 of the display panel 10 may be provided at the same time.

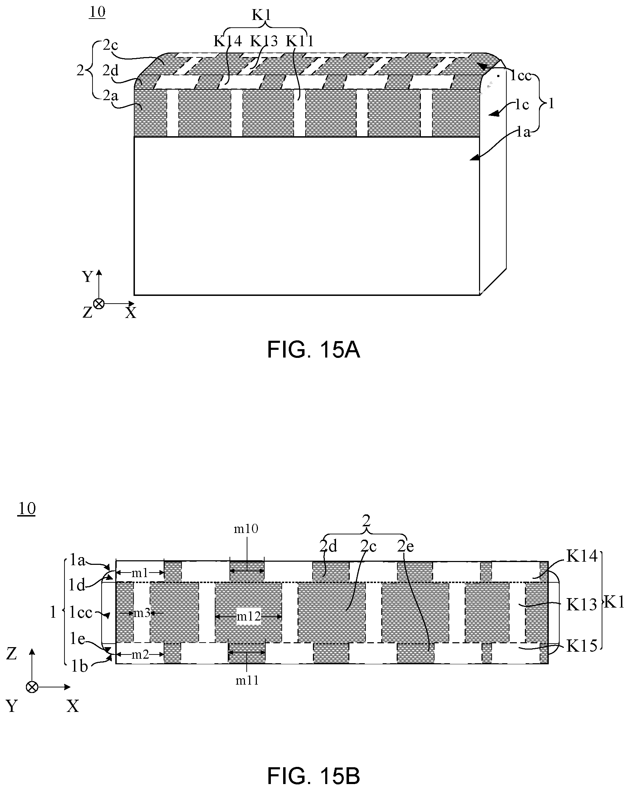

For example, as shown in FIGS. 15A and 15B, FIGS. 15A and 15B are a diagram showing a structure of the display panel 10, in accordance with some embodiments of the present disclosure. The first transition depression sub-region K14 is located on the first chamfered surface 1d of the substrate 1, and the second transition depression sub-region K15 is located on the second chamfered surface 1e of the substrate 1. The dimension m1 of the first transition depression sub-region K14 in the first direction X and the dimension m2 of the second transition depression sub-region K15 in the first direction X are both greater than the dimension m3 of the side depression sub-region K13 in the first direction X. That is to say, the dimension m1 of the first transition depression sub-region K14 in the first direction X and the dimension m2 of the second transition depression sub-region K15 in the first direction X are increased.

It may be understood that, since the dimension m1 of the first transition depression sub-region K14 in the first direction X and the dimension m2 of the second transition depression sub-region K15 in the first direction X increase, a dimension m10 of the first transition lead segment 2d of the connection lead 2 between two adjacent first transition depression sub-regions K14 in the first direction X is reduced, and a dimension m11 of the second transition lead segment 2e of the connection lead 2 between two adjacent second transition depression sub-regions K15 in the first direction X is also reduced, and both are less than a dimension m12 of the side lead segment 2c of the connection lead 2 between two adjacent side depression sub-regions K13 in the first direction X.

For example, as shown in FIG. 15B, the dimension m1 of the first transition depression sub-region K14 in the first direction X is less than or equal to 120 µm and greater than or equal to 50 µm.

For example, the dimension m1 of the first transition depression sub-region K14 in the first direction X may be 50 µm, 55 µm, 60 µm, 63 µm, 66 µm, 75 µm, 80 µm, 83 µm, 88 µm, 90 µm, 96 µm, 100 µm, 105 µm, 110 µm, 112 µm, 118 µm or 120 µm.

For example, as shown in FIG. 15B, the dimension m2 of the second transition depression sub-region K15 in the first direction X is less than or equal to 120 µm and greater than or equal to 50 µm.

For example, the dimension m2 of the second transition depression sub-region K15 in the first direction X may be 50 µm, 55 µm, 60 µm, 63 µm, 66 µm, 75 µm, 80 µm, 83 µm, 88 µm, 90 µm, 96 µm, 100 µm, 105 µm, 110 µm, 112 µm, 118 µm or 120 µm.

For example, as shown in FIG. 15B, the dimension m3 of the side depression sub-region K13 in the first direction X is less than or equal to 45 µm and greater than or equal to 25 µm.

For example, the dimension m3 of the side depression sub-region K13 in the first direction X may be 25 µm, 26 µm, 28 µm, 30 µm, 33 µm, 36 µm, 39 µm, 41 µm, 43 µm or 45 µm.

In some embodiments, a dimension of the connection lead 2 in the first direction X is greater than or equal to 60 µm.

For example, as shown in FIG. 15B, the dimension m10 (i.e., a distance between two adjacent first transition depression sub-regions K14 in the first direction X) of the first transition lead segment 2d of the connection lead 2 in the first direction X is less than or equal to 140 µm and greater than or equal to 60 µm.

For example, the dimension m10 of the first transition lead segment 2d of the connection lead 2 in the first direction X may be 60 µm, 66 µm, 68 µm, 73 µm, 75 µm, 80 µm, 85 µm, 88 µm, 90 µm, 93 µm, 96 µm, 100 µm, 105 µm, 110 µm, 112 µm, 120 µm, 126 µm, 130 µm, 135 µm or 140 µm.

For example, as shown in FIG. 15B, the dimension m11 (i.e., a distance between two adjacent second transition depression sub-regions K15 in the first direction X) of the second transition lead segment 2e of the connection lead 2 in the first direction X is less than or equal to 140 µm and greater than or equal to 60 µm.

For example, the dimension m11 of the second transition lead segment 2e of the connection lead 2 in the first direction X may be 60 µm, 66 µm, 68 µm, 73 µm, 75 µm, 80 µm, 85 µm, 88 µm, 90 µm, 93 µm, 96 µm, 100 µm, 105 µm, 110 µm, 112 µm, 120 µm, 126 µm, 130 µm, 135 µm or 140 µm.

For example, as shown in FIG. 15B, the dimension m12 (i.e., a distance between two adjacent side depression sub-regions K13 in the first direction X) of the side lead segment 2c of the connection lead 2 in the first direction X is less than or equal to 170 µm and greater than or equal to 150 µm.

For example, the dimension m12 of the side lead segment 2c of the connection lead 2 in the first direction X may be 150 µm, 152 µm, 155 µm, 158 µm, 160 µm, 165 µm, 168 µm or 170 µm.

Embodiments of the arrangement of the first depression sub-region K11 of the depression region K1 are described below.

In some embodiments, with continued reference to FIG. 5A, a dimension of the first depression sub-region K11 located on the first surface 1a of the substrate 1 in the first direction X is the same as the dimension of the side depression sub-region K13 in the first direction X, and both are m1'.

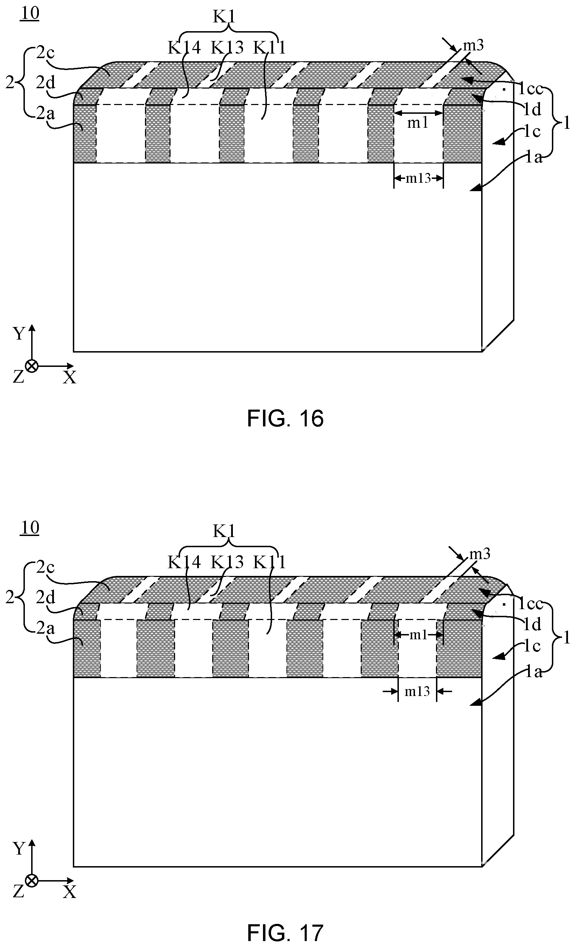

In some other embodiments, as shown in FIGS. 16 and 17, FIGS. 16 and 17 each are a diagram showing a structure of the display panel 10, in accordance with some embodiments of the present disclosure. A dimension m13 of the first depression sub-region K11 located on the first surface 1a of the substrate 1 in the first direction X is greater than the dimension m3 of the side depression sub-region K13 in the first direction X.

The dimension of the first depression sub-region K11 in the first direction X is increased by setting the dimension m13 of the first depression sub-region K11 in the first direction X to be greater than the dimension m3 of the side depression sub-region K13 in the first direction X.

In one aspect, it may be understood that the first depression sub-region K11 separates the first lead segments 2a of two adjacent connection leads 2, the dimension of the first depression sub-region K11 in the first direction X is the same as a distance between the two first lead segments 2a on two sides of the first depression sub-region K11, and both are m13. Therefore, the dimension m13 of the first depression sub-region K11 in the first direction X is increased, which may be equivalent to that the distance m13 between two first lead segments 2a on two sides of the first depression sub-region K11 is increased. In a case where the distance m13 between two first lead segments 2a on two sides of the first depression sub-region K11 increases, when the first lead segment 2a and the first transition lead segment 2d of the connection lead 2 located on the first surface 1a are connected with each other, the probability of misalignment connection between the first lead segment 2a and the first transition lead segment 2d of the connection lead 2 may be reduced, thereby ensuring the normal display of the display panel 10.

It will be noted that, the embodiments shown in FIGS. 16 and 17 are described by considering an example in which the substrate 1 includes only the first chamfered surface 1d. In a case where the substrate 1 does not include the first chamfered surface 1d, the arrangement described above may also be performed on the first depression sub-region K11 of the depression region K1, and the probability of misaligned connection between the first lead segment 2a and the first transition lead segment 2d of the connection lead 2 may be reduced, thereby ensuring the normal display of the display panel 10.

For example, as shown in FIGS. 16 and 17, the dimension m13 of the first depression sub-region K11 in the first direction X is less than or equal to 120 µm and greater than or equal to 50 µm.

For example, the dimension m13 of the first depression sub-region K11 in the first direction X may be 50 µm, 55 µm, 60 µm, 63 µm, 66 µm, 75 µm, 80 µm, 83 µm, 88 µm, 90 µm, 96 µm, 100 µm, 105 µm, 110 µm, 112 µm, 118 µm or 120 µm.

For example, as shown in FIG. 16, the dimension m13 of the first depression sub-region K11 in the first direction X and the dimension m1 of the first transition depression sub-region K14 in the first direction X may be same; alternatively, as shown in FIG. 17, the dimension m13 of the first depression sub-region K11 in the first direction X may also be different from the dimension m1 of the first transition depression sub-region K14 in the first direction X. For example, the dimension m13 of the first depression sub-region K11 in the first direction X is less than the dimension m1 of the first transition depression sub-region K14 in the first direction X.

In a case where the dimension m13 of the first depression sub-region K11 in the first direction X and the dimension m1 of the first transition depression sub-region K14 in the first direction X are same, there is no need to adjust etching sizes when the conductive layer D is etched to form the first depression sub-region K11 and the first transition depression sub-region K14, which may simplify the etching steps and is conducive to improving the etching efficiency.

Although some embodiments of the present disclosure about the arrangement of the first depression sub-region K11 are described herein in combination with FIGS. 16 and 17, the above description is exemplary and not exhaustive. Therefore, some embodiments of the present disclosure are not limited to the disclosed embodiments. Many modifications and variations will be apparent to those of ordinary skill in the art without deviating from the scope of the embodiments described above. For example, the embodiments of the arrangement of the first transition depression sub-region K14 shown in FIGS. 9A to 11, the embodiments of the arrangement of the second transition depression sub-region K15 shown in FIGS. 12 to 14, and the embodiments of the arrangement of the first depression sub-region K11 shown in FIGS. 16 and 17 may be optionally combined. That is to say, any two or three of the first transition depression sub-region K14, the second transition depression sub-region K15 and the first depression sub-region K11 of the display panel 10 may be provided at the same time.

The method for manufacturing the display panel 10 is described in detail below.

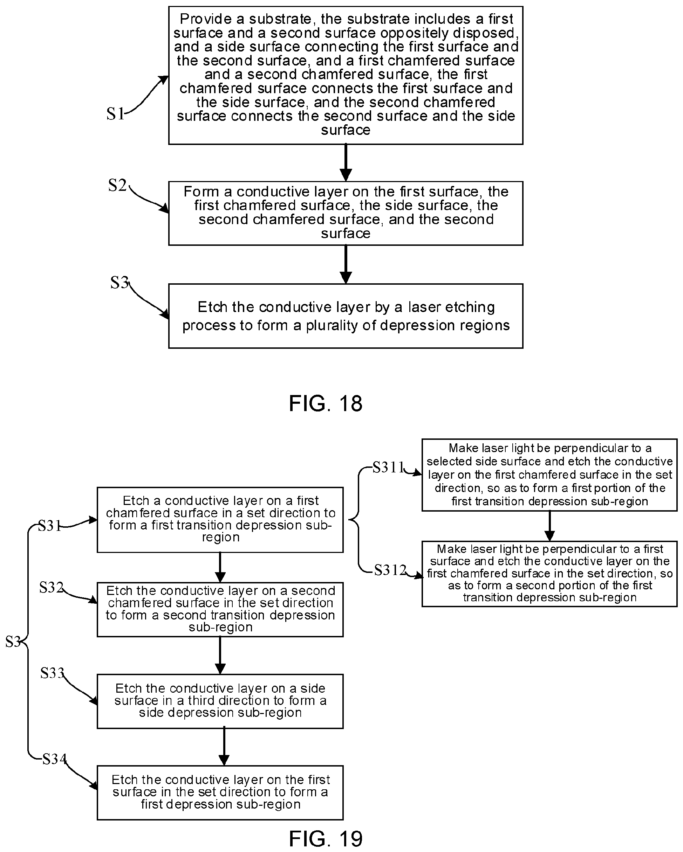

As shown in FIG. 18, FIG. 18 is a flow chart of a method for manufacturing the display panel 10, in accordance with some embodiments of the present disclosure. The method for manufacturing the display panel 10 includes the following steps.

In S1, a substrate 1 is provided. The substrate 1 includes a first surface 1a and a second surface 1b oppositely disposed, and a side surface 1c connecting the first surface 1a and the second surface 1b, and a first chamfered surface 1d and a second chamfered surface 1e. The first chamfered surface 1d connects the first surface 1a and the side surface 1c, and the second chamfered surface 1e connects the second surface 1b and the side surface 1c.

In S2, a conductive layer D is formed on the first surface 1a, the second surface 1b, the side surface 1c (i.e., the selected side surface 1cc), the first chamfered surface 1d, and the second chamfered surface 1e. The conductive layer D includes a first portion D1 located on the first surface 1a of the substrate 1, a fourth portion D4 located on the first chamfered surface 1d of the substrate 1, a third portion D3 located on the selected side surface 1cc of the substrate 1, a fifth portion D5 located on the second chamfered surface 1e of the substrate 1, and a second portion D2 located on the second surface 1b of the substrate 1. The first portion D1, the fourth portion D4, the third portion D3, the fifth portion D5, and the second portion D2 are connected in sequence.

In S3, the conductive layer D is etched by a laser etching process to form a plurality of depression regions K1.

As shown in FIGS. 9A to 14, the depression regions K1 extend from the first surface 1a to the second surface 1b through the first chamfered surface 1d, the selected side surface 1cc and the second chamfered surface 1e in sequence. The depression region K1 includes a first depression sub-region K11 located on the first surface 1a, a second depression sub-region K12 located on the second surface 1b, a side depression sub-region K13 located on the selected side surface 1cc, a first transition depression sub-region K14 located on at least the first chamfered surface 1d, and a second transition depression sub-region K15 located on at least the second chamfered surface 1e.

With continued reference to FIGS. 9A to 14, a connection lead 2 is formed between two adjacent depression regions K1. The connection lead 2 includes a first lead segment 2a located on the first surface 1a, a second lead segment 2b located on the second surface 1b, a side lead segment 2c located on the selected side surface 1cc, a first transition lead segment 2d located on the first chamfered surface 1d, and a second transition lead segment 2e located on the second chamfered surface 1e.

It will be noted that the "a first transition depression sub-region K14 located on at least the first chamfered surface 1d" means that, as shown in FIGS. 9A to 9C, the first transition depression sub-region K14 may be disposed on only the first chamfered surface 1d of the substrate 1; alternatively, as shown in FIGS. 10A to 11, the first transition depression sub-region K14 may also extend toward the selected side surface 1cc or the first surface 1a of the substrate 1; alternatively, the first transition depression sub-region K14 may also extend toward both the selected side surface 1cc and the first surface 1a of the substrate 1.

The "a second transition depression sub-region K15 located on at least the second chamfered surface 1e" means that, as shown in FIG. 12, the second transition depression sub-region K15 may be disposed on only the second chamfered surface 1e of the substrate 1; alternatively, as shown in FIGS. 13A to FIG. 14, the second transition depression sub-region K15 may also extend toward the selected side surface 1cc or the second surface 1b of the substrate 1; alternatively, the second transition depression sub-region K15 may also extend toward both the selected side surface 1cc and the second surface 1b of the substrate 1.

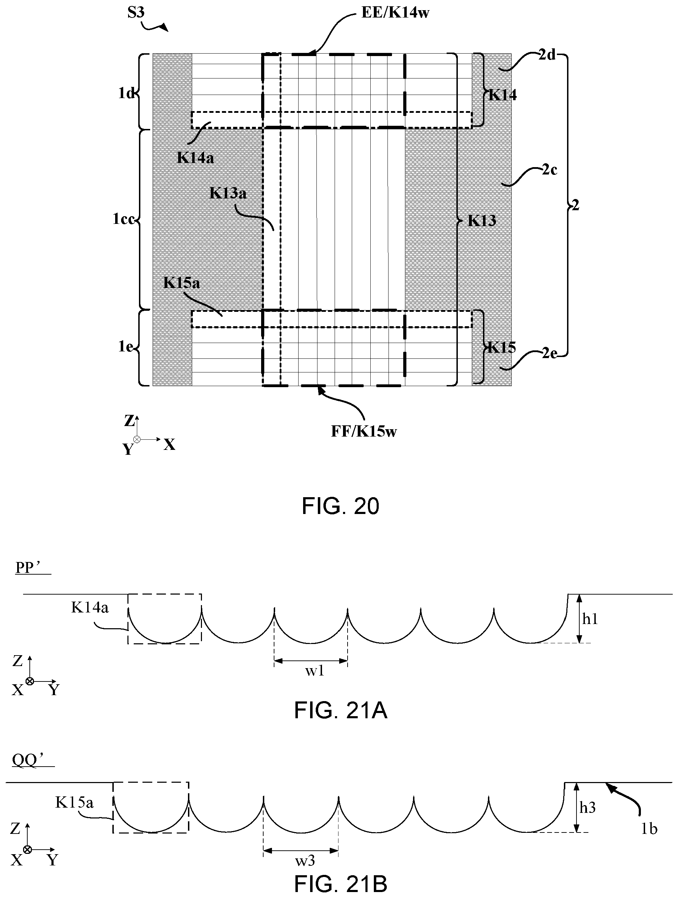

In some embodiments, as shown in FIGS. 19 and 20, FIG. 19 is a flow chart of the step S3 in the method for manufacturing the display panel 10 in FIG. 18, and FIG. 20 is a diagram showing a structure of the display panel 10 corresponding to the step S3 in the method for manufacturing the display panel 10 in FIG. 19.

The step S3 in the method for manufacturing the display panel 10 includes the following steps.

In S31, the conductive layer D (i.e., the fourth portion D4 of the conductive layer D) on the first chamfered surface 1d is etched in a set direction to form the first transition depression sub-region K14. The set direction is parallel to the first direction X, or there is an included angle between the set direction and the first direction X, and the included angle is an acute angle.

In S32, the conductive layer D (i.e., the fifth portion D5 of the conductive layer D) on the second chamfered surface 1e is etched in the set direction to form the second transition depression sub-region K15.

In S33, the conductive layer D (i.e., the third portion D3 of the conductive layer D) on the side surface 1c (i.e., the selected side surface 1cc) is etched in the third direction Z to form the side depression sub-region K13.

It will be noted that there is no limitation on the sequence of the steps S31, S32 and S33.

It will be noted that FIG. 20 illustrates an example in which the set direction is parallel to only the first direction X.

The extending directions of the first transition groove K14a and the second transition groove K15a are the set direction, and the set direction is parallel to the first direction X, or the included angle between the set direction and the first direction X is an acute angle, and the extending direction of the side groove K13a is the third direction Z, and the third direction Z and the first direction X are perpendicular to each other. That is to say, the extending directions of the first transition groove K14a and the second transition groove K15a both are different from the extending direction of the side groove K13a. Therefore, it is necessary to etch the fourth portion D4 and the fifth portion D5 of the conductive layer D separately. Moreover, since the set direction is parallel to the first direction X, or, the included angle between the set direction and the first direction X is an acute angle, when the fourth portion D4 and the fifth portion D5 of the conductive layer D are etched by laser light, in the first direction X, the defocus amount (i.e., a distance between the laser focus and the fourth portion D4 or the fifth portion D5 of the conductive layer D) of the etched region of the fourth portion D4 or the fifth portion D5 of the conductive layer D is constant or has a small difference, which is conducive to improving the etching quality at the first chamfered surface 1d and the second chamfered surface 1e, and reducing the probability that the conductive patterns Q are residual in the first transition depression sub-region K14 and the second transition depression sub-region K15.

In some embodiments, with continued reference to FIG. 20, a plurality of first transition grooves K14a extending in the set direction are disposed in the first transition depression sub-region K14. The plurality of first transition grooves K14a may be formed by laser etching, and the plurality of first transition grooves K14a are arranged in parallel.

A plurality of second transition grooves K15a extending in the set direction are disposed in the second transition depression sub-region K15. The plurality of second transition grooves K15a may be formed by laser etching, and the plurality of second transition grooves K15a are arranged in parallel.

It may be understood that in a case where the set direction of each of the plurality of first transition grooves K14a in the first transition depression sub-region K14 is same, the plurality of first transition grooves K14a in the first transition depression sub-region K14 are parallel to each other. In a case where the set direction of each of the plurality of second transition grooves K15a in the second transition depression sub-region K15 is same, the plurality of second transition grooves K15a in the second transition depression sub-region K15 are also parallel to each other. For example, since the first transition depression sub-region K14 is provided with the plurality of first transition grooves K14a extending in the set direction (e.g., the first direction X), the first transition depression sub-region K14 has a stripe-like shape in the set direction (e.g., the first direction X). Similarly, since the second transition depression sub-region K15 is provided with the plurality of second transition grooves K15a extending in the set direction (e.g., the first direction X), the second transition depression sub-region K15 has a stripe-like shape in the set direction (e.g., the first direction X).

In some embodiments, with continued reference to FIG. 20, a plurality of side grooves K13a extending in the third direction Z are disposed in the side depression sub-region K13 of each depression region K1, and the plurality of side grooves K13a are arranged in parallel.

It will be noted that the "the plurality of side grooves K13a are arranged in parallel" means that the plurality of side grooves K13a are arranged in the first direction X on the selected side surface 1cc of the substrate 1.

For example, the side depression sub-region K13 extends to the first chamfered surface 1d of the substrate 1, and the first transition depression sub-region K14 extends to the selected side surface 1cc of the substrate 1. That is to say, there is a first overlapping region EE as shown in FIG. 20 in the side depression sub-region K13 and the first transition depression sub-region K14. The side depression sub-region K13 is provided with the plurality of side grooves K13a extending in the third direction Z and arranged in the first direction X, and the first transition depression sub-region K14 is provided with the plurality of first transition grooves K14a extending in the set direction (e.g., the first direction X). That is to say, the side grooves K13a in the side depression sub-region K13 are disposed perpendicular to the first transition grooves K14a in the first transition depression sub-region K14. Therefore, in the first overlapping region EE shown in FIG. 20, the plurality of side grooves K13a in the side depression sub-region K13 and the plurality of first transition grooves K14a in the first transition depression sub-region K14 together form the first grid-like depression portion K14W.

Through the above arrangement, when the side depression sub-region K13 and the first transition depression sub-region K14 are formed by a laser etching process, the first overlapping regions EE in the side depression sub-region K13 and the first transition depression sub-region K14 are etched separately, which is conducive to improving the etching quality of the first overlapping region EE and reducing the probability that the conductive pattern Q is residual in the first overlapping region EE.

For example, the side depression sub-region K13 extends to the second chamfered surface 1e of the substrate 1, and the second transition depression sub-region K15 extends to the selected side surface 1cc of the substrate 1. That is to say, there is a second overlapping region FF as shown in FIG. 20 in the side depression sub-region K13 and the second transition depression sub-region K15. The side depression sub-region K13 is provided with the plurality of side grooves K13a extending in the third direction Z and arranged in the first direction X, and the second transition depression sub-region K15 is provided with the plurality of second transition grooves K15a extending in the set direction (e.g., the first direction X). That is to say, the side grooves K13a in the side depression sub-region K13 are disposed perpendicular to the second transition grooves K15a in the second transition depression sub-region K15. Therefore, in the second overlapping region FF shown in FIG. 20, the plurality of side grooves K13a in the side depression sub-region K13 and the plurality of second transition grooves K15a in the second transition depression sub-region K15 together form the second grid-like depression portion K15W.

Through the above arrangement, when the side depression sub-region K13 and the second transition depression sub-region K15 are formed by a laser etching process, the second overlapping regions FF in the side depression sub-region K13 and the second transition depression sub-region K15 are etched separately, which is conducive to improving the etching quality of the second overlapping region FF, and reducing the probability that the conductive pattern Q is residual in the first overlapping region EE.

In some embodiments, as shown in FIG. 21A, FIG. 21A is a sectional view of the first transition grooves K14a in FIG. 8E taken along the section line P-P'.

A depth h1 of each first transition groove K14a is within a range of 1 µm to 3 µm, inclusive. A width w1 of each first transition groove K14a is within a range of 1 µm to 10 µm, inclusive.

For example, the depth h1 of each first transition groove K14a may be 1 µm, 1.2 µm, 1.6 µm, 2 µm, 2.1 µm, 2.3 µm, 2.6 µm, 2.8 µm, or 3 µm.

The width w1 of each first transition groove K14a may be 1 µm, 2 µm, 3 µm, 4 µm, 5 µm, 6 µm, 7 µm, 8 µm, 9 µm, and 10 µm.

It will be noted that the "depth of the first transition groove K14a" refers to a distance between a lowest end of a transition groove K14a and the corresponding surface (e.g., the first surface 1a of the substrate 1 shown in FIG. 21A) of the substrate 1 where the first transition groove K14a is located. FIG. 21A illustrates an example in which the depths h1 of the plurality of first transition grooves K14a in the first transition depression sub-region K14 are same. However, the arrangement of the depths h1 of the plurality of first transition grooves K14a in the first transition depression sub-region K14 in the present disclosure is not limited thereto. For example, there are at least two first transition grooves K14a with different depths h1 in the plurality of first transition grooves K14a in the first transition depression sub-region K14.

The "width of the first transition groove K14a" refers to a maximum dimension of the first transition groove K14a in the extending direction (that is, the extending direction of the depression region K1 is the second direction Y on the first surface 1a of the substrate 1) of the depression region K1. FIG. 21A illustrates an example in which the widths w1 of the plurality of first transition grooves K14a in the first transition depression sub-region K14 are same. However, the arrangement of the widths w1 of the plurality of first transition grooves K14a in the first transition depression sub-region K14 in the present disclosure is not limited thereto. For example, there are at least two first transition grooves K14a with different widths w1 in the plurality of first transition grooves K14a in the first transition depression sub-region K14.

In some embodiments, as shown in FIG. 21B, FIG. 21B is a sectional view of the second transition grooves K15a in FIG. 8E taken along the section line Q-Q'.

A depth h3 of each second transition groove K15a is within a range of 1 µm to 3 µm, inclusive. A width w3 of each second transition groove K15a is within a range of 1 µm to 10 µm, inclusive.

For example, the depth h3 of each second transition groove K15a may be 1 µm, 1.2 µm, 1.6 µm, 2 µm, 2.1 µm, 2.3 µm, 2.6 µm, 2.8 µm, or 3 µm.

The width w3 of each second transition groove K15a may be 1 µm, 2 µm, 3 µm, 4 µm, 5 µm, 6 µm, 7 µm, 8 µm, 9 µm, or 10 µm. It will be noted that the "depth of the second transition groove K15a" refers to a distance between a lowest end of the second transition groove K15a and the corresponding surface (e.g., the second surface 1b of the substrate 1 shown in FIG. 21B) of the substrate 1 where the second transition groove K15a is located. FIG. 21B illustrates an example in which the depths h3 of the plurality of second transition grooves K15a in the second transition depression sub-region K15 are same. However, the arrangement of the depths h3 of the plurality of second transition grooves K15a in the second transition depression sub-region K15 in the present disclosure is not limited thereto. For example, there are at least two second transition grooves K15a with different depths h3 in the plurality of second transition grooves K15a in the second transition depression sub-region K15.

The "width of the second transition groove K15a" refers to a maximum dimension of the second transition groove K15a in a direction perpendicular to the extending direction of the second transition groove K15a. FIG. 21B illustrates an example in which the widths w3 of the plurality of second transition grooves K15a in the second transition depression sub-region K15 are same. However, the arrangement of the widths w3 of the plurality of second transition grooves K15a in the second transition depression sub-region K15 in the present disclosure is not limited thereto. For example, there are at least two second transition grooves K15a with different widths w3 in the plurality of second transition grooves K15a in the second transition depression sub-region K15.

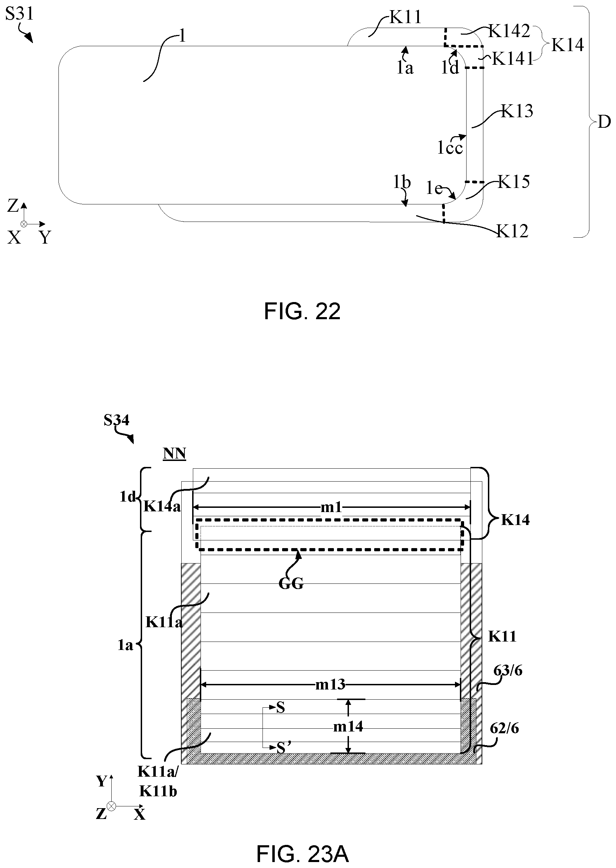

In some embodiments, as shown in FIGS. 19 and 22, FIG. 22 is a diagram showing a structure of the first transition depression sub-region K14 of the display panel 10 corresponding to the step S31 in the method for manufacturing the display panel 10 in FIG. 19.

The step S31 in the method for manufacturing the display panel 10 includes the following steps.

In S311, laser light is made to be perpendicular to the selected side surface 1cc of the substrate 1 and etches the conductive layer D (i.e., the fourth portion D4 of the conductive layer D) on the first chamfered surface 1d of the substrate 1 in the set direction, so as to form a first portion K141 of the first transition depression sub-region K14. The etching range of the laser light does not exceed the plane where the first surface 1a of the substrate 1 is located.

In S312, laser light is made to be perpendicular to the first surface 1a of the substrate 1 and etches the conductive layer D (i.e., the fourth portion D4 of the conductive layer D) on the first chamfered surface 1d of the substrate 1 in the set direction, so as to form a second portion K142 of the first transition depression sub-region K14.

As shown in FIG. 22, the first transition depression sub-region K14 includes the first portion K141 and the second portion K142. When the first portion K141 of the first transition depression sub-region K14 is formed, the laser light is perpendicular to the selected side surface 1cc of the substrate 1, and the etching range of laser light does not exceed the plane where the first surface 1a of the substrate 1 is located. That is to say, an orthogonal projection of the first portion K141 of the first transition depression sub-region K14 on the selected side surface 1cc of the substrate 1 is within a border range of the selected side surface 1cc of the substrate 1, which may avoid the damage caused by laser light to the insulating layer 6 located on the first surface 1a of the substrate 1 when the first portion K141 of the first transition depression sub-region K14 is formed.

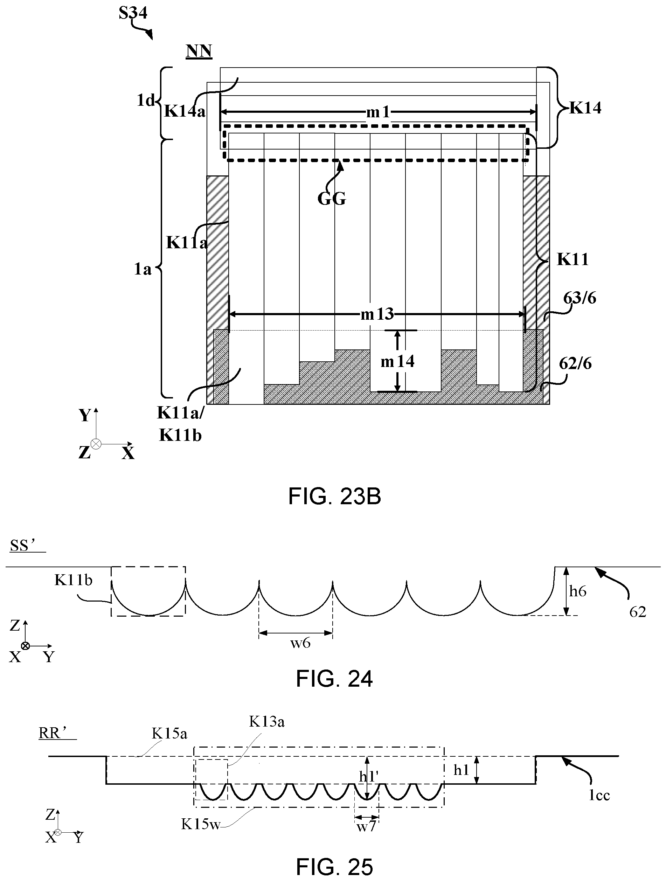

In some embodiments, as shown in FIGS. 19, 23A and 23B, FIGS. 23A and 23B each are a diagram showing a structure of a region NN of the display panel 10 in the embodiment shown in FIG. 4B corresponding to the step S34 in the method for manufacturing the display panel 10 in FIG. 19. The step S3 in the method for manufacturing the display panel 10 further includes step S34.

The conductive layer D (i.e., the first portion D1 of the conductive layer D) on the first surface 1a is etched in the set direction to form the first depression sub-region K11.

It will be noted that FIG. 23A illustrates an example in which the set direction is parallel to the first direction X, but the arrangement of the set direction in the present disclosure is not limited thereto. For example, the set direction may have an included angle with the first direction X, and the included angle is an acute angle.

In some embodiments, with continued reference to FIGS. 8G and 23A, a plurality of first grooves K11a extending in the set direction are disposed in the first depression sub-region K11. The plurality of first grooves K11a are arranged in the extending direction of the depression region K1, and the plurality of first grooves K11a are located on the first surface 1a of the substrate 1.

The "the plurality of first grooves K11a are arranged in the extending direction of the depression region K1" means that the plurality of first grooves K11a in the first depression sub-region K11 are arranged in the second direction Y on the first surface 1a of the substrate 1.

It may be understood that in a case where the set direction of each of the plurality of first grooves K11a in the first depression sub-region K11 is same, the plurality of first grooves K11a in the first depression sub-region K11 are parallel to each other.

For example, the first depression sub-region K11 extends to the first chamfered surface 1d of the substrate 1, and the first transition depression sub-region K14 extends to the first surface 1a of the substrate 1. That is to say, there is a third overlapping region GG as shown in FIG. 23A in the first depression sub-region K11 and the first transition depression sub-region K14. The first depression sub-region K11 is provided with the plurality of first grooves K11a extending in the set direction (e.g., the first direction X) and arranged in the second direction Y, and the first transition depression sub-region K14 is provided with the plurality of first transition grooves K14a extending in the set direction (e.g., the first direction X). That is to say, the side grooves K13a in the side depression sub-region K13 and the first transition grooves K14a in the first transition depression sub-region K14 are disposed parallel to each other. Therefore, in the third overlapping region GG shown in 23A, the plurality of first grooves K11a in the first depression sub-region K11 and the plurality of first transition grooves K14a in the first transition depression sub-region K14 together form a stripe-like shape.

Through the above arrangement, when the first depression sub-region K11 and the first transition depression sub-region K14 are formed by the laser etching process, the third overlapping regions GG in the first depression sub-region K11 and the first transition depression sub-region K14 are etched separately, which is conducive to improving the etching quality of the third overlapping region GG, and reducing the probability that the conductive pattern Q is residual in the third overlapping region GG.

It will be noted that in FIG. 23A, for the convenience of distinction between the plurality of first grooves K11a in the first depression sub-region K11 and the plurality of first transition grooves K14a in the first transition depression sub-region K14, the dimensions m13 of the plurality of first grooves K11a in the first depression sub-region K11 in the first direction X are set to be less than the dimensions m1 of the plurality of first transition grooves K14a in the first transition depression sub-region K14 in the first direction X. However, the arrangement of the dimensions m13 of the plurality of first grooves K11a in the first depression sub-region K11 in the first direction X and the dimensions m1 of the plurality of first transition grooves K14a in the first transition depression sub-region K14 in the first direction X in the present disclosure is not limited thereto. For example, the dimensions m13 of the plurality of first grooves K11a in the first depression sub-region K11 in the first direction X and the dimensions m1 of the plurality of first transition grooves K14a in the first transition depression sub-region K14 in the first direction X may be same. Alternatively, the dimensions m13 of the plurality of first grooves K11a in the first depression sub-region K11 in the first direction X may be greater than the dimensions m1 of the plurality of first transition grooves K14a in the first transition depression sub-region K14 in the first direction X.

In some embodiments, with continued reference to FIGS. 23A and 23B, a portion of the first depression sub-region K11 extends to the first insulating layer 62. This is conducive to fully etching the first portion D1 of the conductive layer D at the border of the insulating layer 6, thereby avoiding a case where the conductive layer D is residual in the first depression sub-region K11, which causes the short circuit of the connection leads 2 and affecting the normal display of the display panel 10.

In some examples, as shown in FIG. 23B, a plurality of first grooves K11a are disposed in the first depression sub-region K11, and at least part region of the plurality of first grooves K11a overlaps with the first insulating layer 62.

The plurality of first grooves K11a extend in the second direction Y and are arranged in the first direction X. At least part region of the plurality of first grooves K11a overlaps with the insulating layer 6, which means that the first groove(s) K11a extend to the first insulating layer 62 in the insulating layer 6. Here, the portion of the first groove extending to the first insulating layer 62 in the insulating layer 6 is referred to as an insulating layer groove K11b. The insulating layer groove(s) K11b are located on a surface of the insulating layer 6. For example, the insulating layer groove K11b is located on a surface of the first insulating layer 62.

In a case where the insulating layer grooves K11b extend in the second direction Y and are arranged in the first direction X, portions of the plurality of first grooves away from the selected side surface all extend to the first insulating layer 62. That is to say, during the etching process, the insulating layer grooves K11b will cause certain damage to the surface of the first insulating layer. Dimensions of the plurality of first grooves in the second direction Y are different. That is to say, end surfaces of the plurality of first grooves K11a away from the selected side surface 1cc are not flush and have a crescent shape.

In some other examples, as shown in FIG. 23A, a plurality of first grooves K11a are disposed in the first depression sub-region K11, and at least one of the plurality of first grooves overlaps with the insulating layer.

The plurality of first grooves extend in the set direction, and the set direction is the first direction X, or an included angle between the set direction and the first direction X is less than 15°. The "at least one first groove overlaps with the insulating layer" means that there is at least one first groove in the plurality of first grooves that is away from the selected side surface and located on the first insulating layer 62. The first groove K11a overlapping with the first insulating layer 62 is referred to as the insulating layer groove K11b.

As shown in FIG. 23A, a total dimension m14 (i.e., a dimension of a portion of the first depression sub-region K11 extending to the insulating layer 6) of the plurality of insulating layer grooves K11b in the second direction Y may be adjusted by adjusting the number of the insulating layer grooves K11b. Therefore, when the first depression region K11 is formed, and when the laser light etches into a region where the insulating layer 6 is located, the total dimension m14 of the plurality of insulating layer grooves K11b in the second direction Y may be controlled by controlling the number of the insulating layer grooves K11b, so as to avoid excessive damage to the first insulating layer 62 caused by the laser light.

The "excessive damage to the first insulating layer 62" refers to that the performance of the first insulating layer 62 is affected. For example, the performance of the first insulating layer 62 in blocking the organic material of the encapsulation layer of the display panel 10 is reduced, which may cause the organic material of the encapsulation layer of the display panel 10 to overflow.

The "the total dimension of the plurality of insulating layer grooves K11b in the second direction Y is adjusted" may be achieved, for example, by adjusting a dimension of the insulating layer groove K11b in the second direction Y, or by adjusting the number of the insulating layer grooves K11b.

It may be understood that in a case where the set direction of each of the plurality of insulating layer grooves K11b is same, the plurality of insulating layer grooves K11b are parallel to each other. For example, as shown in FIG. 23A, the set direction of each of the plurality of insulating layer grooves K11b is the first direction X.

Furthermore, in a case where the set direction of each of the plurality of insulating layer grooves K11b is the same as the set direction of each of the plurality of first grooves K11a, the plurality of insulating layer grooves K11b and the plurality of first grooves K11a are parallel to each other. For example, as shown in FIG. 22, the set direction of each of the plurality of insulating layer grooves K11b and the set direction of each of the plurality of first grooves K11a both are the first direction X.

In some embodiments, as shown in FIG. 24, FIG. 24 is a diagram showing a structure of the insulating layer groove K11b, in accordance with some embodiments of the present disclosure.

A depth h6 of each insulating layer groove K11b is within a range of 1 µm to 3 µm, inclusive. A width w6 of each insulating layer groove K11b is within a range of 1 µm to 10 µm, inclusive.

For example, the depth h6 of each insulating layer groove K11b may be 1 µm, 1.2 µm, 1.6 µm, 2 µm, 2.1 µm, 2.3 µm, 2.6 µm, 2.8 µm, or 3 µm.

The depth h6 of each insulating layer groove K11b may be 1 µm, 2 µm, 3 µm, 4 µm, 5 µm, 6 µm, 7 µm, 8 µm, 9 µm, or 10 µm. It will be noted that the "depth of the insulating layer groove K11b" refers to a distance between a lowest end of the insulating layer groove K11b and the upper surface 6a (that is, the upper surface 6a of the insulating layer 6 refers to a surface of the insulating layer 6 away from the substrate 1) of the insulating layer 6. FIG. 24 illustrates an example in which the depths h6 of the plurality of insulating layer grooves K11b are same. However, the arrangement of the depths h6 of the plurality of insulating layer grooves K11b in the present disclosure is not limited thereto. For example, there are at least two insulating layer grooves K11b with different depths h6 in the plurality of insulating layer grooves K11b.

The "width of the insulating layer groove K11b" refers to a maximum dimension of the insulating layer groove K11b in the second direction Y. FIG. 24 illustrates an example in which the widths w6 of the plurality of insulating layer grooves K11b are same. However, the arrangement of the widths w6 of the plurality of insulating layer grooves K11b in the present disclosure is not limited thereto. For example, there are at least two insulating layer grooves K11b with different widths w6 in the plurality of insulating layer grooves K11b.

FIG. 21A illustrates an example in which the plurality of first transition grooves K14a disposed in the first transition depression sub-region K14 are in contact with each other but not overlap with each other, FIG. 21B illustrates an example in which the plurality of second transition grooves K15a disposed in the second transition depression sub-region K15 are in contact with each other but not overlap with each other, and FIG. 24 illustrates an example in which the plurality of insulating layer grooves K11b disposed in the first depression sub-region K11 are in contact with each other in the second direction Y but not overlap with each other. However, the arrangement of the plurality of first transition grooves K14a disposed in the first transition depression sub-region K14, the arrangement of the plurality of second transition grooves K15a disposed in the second transition depression sub-region K15, the arrangement of the plurality of insulating layer grooves K11b disposed in the first depression sub-region K11, the arrangement of the plurality of first grooves K11a disposed in the first depression sub-region K11, and the arrangement of the plurality of side grooves K13a disposed in the side depression sub-region K13 in the present disclosure are not limited thereto.

Other arrangement of the plurality of first transition grooves K14a disposed in the first transition depression sub-region K14 is described below by considering the plurality of first transition grooves K14a disposed in the first transition depression sub-region K14 as an example. The plurality of second transition grooves K15a disposed in the second transition depression sub-region K15, the plurality of insulating layer grooves K11b disposed in the first depression sub-region K11, the plurality of first grooves K11a disposed in the first depression sub-region K11 and the plurality of side grooves K13a disposed in the side depression sub-region K13 may have the same or similar arrangement.

In some embodiments, as shown in FIG. 25, FIG. 25 is a sectional view of the second transition depression sub-region K15 in FIG. 8E taken along the section line R-R'. When the fifth portion D5 of the conductive portion D is etched by laser light to form the plurality of second transition grooves K15a and the plurality of side grooves K13a, in a case where a certain position of the fifth portion D5 of the conductive portion D is etched multiple times (e.g., twice) to form the second grid-like depression portion K15w, for example, the laser light first etches in the first direction to form the plurality of second transition grooves K15a, and then the plurality of side grooves K13a are formed in the third direction Z. A width w7 of the side groove K13a in the second grid-like depression portion K15w is less than a width of the side groove K13a in the side depression sub-region K13, and a distance h1' between the bottom of the side groove K13a and the selected side surface 1cc is greater than the depth h1 of the second transition groove K15a.

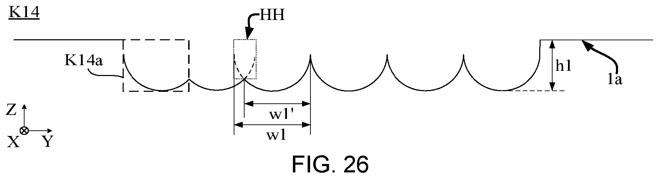

In some embodiments, as shown in FIG. 26, FIG. 26 is a diagram showing a structure of the plurality of first transition grooves K14a, in accordance with some embodiments of the present disclosure. In a process of sequentially forming two adjacent first transition grooves K14a, if there is a fourth overlapping region HH (i.e., the region shown by the dashed line in FIG. 26) between the two, a width w1' of a section of each first transition groove K14a finally formed is reduced and less than the theoretical width w1. In this case, it is possible to avoid a case where the conductive pattern is residual between the two adjacent first transition grooves K14a due to a tolerance or accuracy problem, resulting in the short circuit between two adjacent connection leads 2 formed subsequently.

In some embodiments, referring to FIGS. 8D to 8G, in the first direction X, the numbers of the side grooves K13a in any two depression regions K1 may be same or different. In this way, the plurality of connection traces formed subsequently may have different widths.

Referring to FIGS. 8D to 8G, in a same depression region K1, at least two of the first depression sub-region K11, the second depression sub-region K11, the side depression sub-region K13, the first transition depression sub-region K14, and the second transition depression sub-region K15 have different numbers of grooves. For example, the number of first grooves in the first depression sub-region K11 is different from the number of side grooves in the side depression sub-region K13, the number of first grooves in the first depression sub-region K11 is different from the number of first transition grooves in the first transition depression sub-region K14, and the widths of a same connection lead at different positions are different.

The foregoing descriptions are merely specific implementations of the present disclosure, but the protection scope of the present disclosure is not limited thereto. Changes or replacements that any person skilled in the art could conceive of within the technical scope of the present disclosure shall be included in the protection scope of the present disclosure. Therefore, the protection scope of the present disclosure shall be subject to the protection scope of the claims.

## Claims

1. A display panel, comprising:
a substrate including a first surface and a second surface that are oppositely disposed, and at least one side surface connecting the first surface and the second surface, at least one of the side surface being a selected side surface; and
a plurality of depression regions arranged at intervals in a first direction, each depression region extending from the first surface to the second surface through the selected side surface; each depression region including a first depression sub-region located on the first surface, a second depression sub-region located on the second surface, and a side depression sub-region located on the selected side surface;
wherein each first depression sub-region and each second depression sub-region extend in a second direction; each side depression sub-region extends in a third direction; the second direction is perpendicular to the selected side surface, the first direction is perpendicular to the second direction, and the third direction is perpendicular to the first surface or the second surface;
each depression region further includes a first transition depression sub-region connecting the first depression sub-region and the side depression sub-region, and/or, a second transition depression sub-region connecting the second depression sub-region and the side depression sub-region; and
the first transition depression sub-region includes a first grid-like depression portion, and/or, the second transition depression sub-region includes a second grid-like depression portion.

2. The display panel according to claim 1, wherein the first depression sub-region includes a plurality of first grooves arranged in parallel, the second depression sub-region includes a plurality of second grooves arranged in parallel, and the side depression sub-region includes a plurality of side grooves arranged in parallel.

3. The display panel according to claim 2, wherein a first groove extends to the first transition depression sub-region, and/or, a second groove extends to the second transition depression sub-region, and/or, a side groove extends to the first transition depression sub-region and the second transition depression sub-region;
the first transition depression sub-region includes a plurality of first transition grooves arranged in parallel, an extending direction of a first transition groove has a first included angle with an extending direction of at least one of the first groove and the side groove, and the first transition grooves cross at least one of the first grooves and the side grooves to form the first grid-like depression portion; and/or
the second transition depression sub-region includes a plurality of second transition grooves arranged in parallel, an extending direction of a second transition groove has a second included angle with an extending direction of at least one of the second groove and the side groove, and the second transition grooves cross at least one of the second grooves and the side grooves to form the second grid-like depression portion.

4. The display panel according to any one of claims 1 to 3, wherein a dimension of the first transition depression sub-region in the first direction is greater than or equal to a dimension of the side depression sub-region in the first direction; and/or, a dimension of the second transition depression sub-region in the first direction is greater than or equal to the dimension of the side depression sub-region in the first direction.

5. The display panel according to any one of claims 1 to 4, wherein the substrate further includes a first chamfered surface and a second chamfered surface;
the first chamfered surface connects the first surface and the selected side surface, and the second chamfered surface connects the second surface and the selected side surface; and
the first transition depression sub-region is disposed on at least the first chamfered surface, and the second transition depression sub-region is disposed on at least the second chamfered surface.

6. The display panel according to claim 5, wherein the first transition depression sub-region extends to the selected side surface, and/or, the first transition depression sub-region extends to the first surface.

7. The display panel according to claim 5 or 6, wherein the second transition depression sub-region extends to the selected side surface, and/or, the second transition depression sub-region extends to the second surface.

8. The display panel according to any one of claims 5 to 7, wherein a dimension of an orthogonal projection of the first chamfered surface on a plane where the first surface is located in the second direction is greater than or equal to 10 µm and less than or equal to 50 µm; and
a dimension of an orthogonal projection of the second chamfered surface on a plane where the second surface is located in the second direction is greater than or equal to 10 µm and less than or equal to 50 µm.

9. The display panel according to any one of claims 1 to 8, wherein a dimension of the first depression sub-region in the first direction is greater than or equal to a dimension of the side depression sub-region in the first direction.

10. The display panel according to claim 9, wherein the dimension of the first depression sub-region in the first direction is equal to a dimension of the first transition depression sub-region in the first direction.

11. The display substrate according to any one of claims 1 to 10, wherein a dimension of the depression region in the first direction is greater than or equal to 25 µm.

12. The display panel according to any one of claims 1 to 11, further comprising a plurality of first electrodes located on the first surface of the substrate, the plurality of first electrodes being arranged at intervals in the first direction, wherein
a depression region is disposed between two adjacent first electrodes; and
a dimension of the depression region in the first direction is less than or equal to 70% of a distance between the two first electrodes adjacent thereto.

13. The display panel according to claim 3, wherein the plurality of first transition grooves are parallel to each other; and/or
the plurality of second transition grooves are parallel to each other.

14. The display panel according to claim 3 or 13, wherein a depth of each first transition groove is within a range of 1 µm to 3 µm, inclusive; and/or, a width of each first transition groove is within a range of 1 µm to 10 µm, inclusive; and
a depth of each second transition groove is within a range of 1 µm to 3 µm, inclusive; and/or, a width of each second transition groove is within a range of 1 µm to 10 µm, inclusive.

15. The display panel according to claim 14, wherein at least two of the plurality of first transition grooves have different depths, and/or, at least two of the plurality of first transition grooves have different widths; and
at least two of the plurality of second transition grooves have different depths, and/or, at least two of the plurality of second transition grooves have different widths.

16. The display panel according to claim 6 or 7, wherein the side depression sub-region is provided with a plurality of side grooves extending in the third direction, and the plurality of side grooves are arranged at intervals in the first direction; and
the plurality of side grooves overlap with a plurality of first transition grooves on the selected side surface of the substrate; and/or, the plurality of side grooves overlap with a plurality of second transition grooves on the selected side surface of the substrate.

17. The display panel according to any one of claims 1 to 16, further comprising an insulating layer located on the first surface of the substrate, a border of the insulating layer extending along an edge of the substrate, wherein
the first depression sub-region is provided with a plurality of first grooves, and at least one of the plurality of first grooves or at least partial region of the plurality of first grooves overlaps with the insulating layer.

18. The display panel according to any one of claims 1 to 17, further comprising a connection lead disposed between two adjacent depression regions, the connection lead extending from the first surface to the second surface through the selected side surface, wherein
the connection lead includes a first lead segment located on the first surface, a second lead segment located on the second surface, a side lead segment located on the selected side surface, and a first transition lead segment connecting the first lead segment and the side lead segment and/or a second transition lead segment connecting the second lead segment and the side lead segment; and
a dimension of the first transition lead segment in the first direction is less than or equal to a dimension of the side lead segment in the first direction; and/or, a dimension of the second transition lead segment in the first direction is less than or equal to the dimension of the side lead segment in the first direction.

19. The display panel according to claim 18, wherein the substrate further includes a first chamfered surface and a second chamfered surface;
the first chamfered surface connects the first surface and the selected side surface, and the second chamfered surface connects the second surface and the selected side surface; and
the first transition lead segment is disposed on at least the first chamfered surface, and the second transition lead segment is disposed on at least the second chamfered surface.

20. The display panel according to claim 18 or 19, wherein a dimension of the connection lead in the first direction is greater than or equal to 60 µm.

21. The display panel according to any one of claims 17 to 20, further comprising a protective layer, the protective layer is filled in the plurality of depression regions and covers surfaces of a plurality of connection leads away from the substrate.

22. A display apparatus, comprising:
the display panel according to any one of claims 1 to 21, wherein the display panel includes a plurality of connection leads, and a connection lead is disposed between each two adjacent depression regions; and
a circuit board electrically connected to the plurality of connection leads.

23. A tiled display apparatus, comprising:
a plurality of display panels each according to any one of claims 1 to 21, wherein the plurality of display panels are tiled together; each display panel includes a plurality of connection leads, and a connection lead is disposed between each two adjacent depression regions; and
at least one circuit board, wherein each circuit board is electrically connected to a plurality of connection leads of at least one of the display panels.
